# EUROPEAN PATENT SPECIFICATION

(11) **EP 3 214 152 B1**
(45) Date of publication and mention of the grant of the patent: **04.07.2018**
(21) Application number: 16158203.6
(22) Date of filing: 02.03.2016
(51) Int. Cl.: C09K 11/06, H01L 51/00, H01L 51/50

(54) **SILICON-BASED EMITTER COMPOUND**
SILICIUMBASIERTE EMITTERVERBINDUNG
COMPOSÉ D'ÉMETTEUR À BASE DE SILICIUM

(43) Date of publication of application: 06.09.2017
(73) Proprietor: cynora GmbH, 76646 Bruchsal (DE)
(72) Inventor: Öner, Saliha, 35050 Bornova-Izmir (TR); Öner, Ilker, 35050 Bornova-Izmir (TR); Varlikli, Canan, 35600 Karsiyaka-Izmir (TR); Jacob, Andreas, 76137 Karlsruhe (DE); Seifermann, Stefan, 77815 Bühl (DE); Volz, Daniel, 76137 Karlsruhe (DE)
(74) Representative: Jacobi, Markus Alexander

(56) References cited:
- JP-A- 2011 140 475
- US-A1- 2013 264 518
- US-A1- 2014 158 992

## Description

The present invention relates to emitter compounds E of formula (I) or salts thereof based on a triazine core structure, which is substituted with at least one moiety of the general formula (Ia) 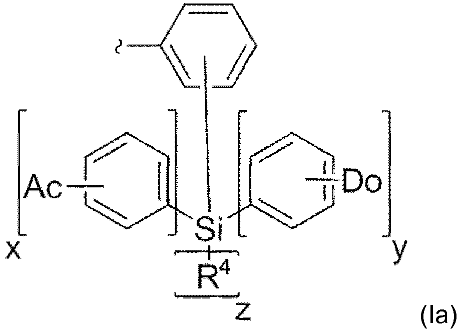 and at least one donor moiety. Further, the present invention also refers to a light-emitting layer B, comprising the emitter compound E and to an opto-electronic device OD, comprising such light-emitting layer B. Moreover, the present invention relates to a method for generating light of a desired wavelength range by means of the opto-electronic device OD.

Opto-electronic devices based on organics such as organic light emitting diodes (OLEDs), light emitting electrochemical cells (LECs), organic lasers, organic solar cells (OSCs) and optical sensors, gain increasing importance. In particular, OLEDs and LECs are promising devices for electronic products such as, e.g., screens, displays and illumination devices. In contrast to most opto-electronic devices essentially based on inorganics only, opto-electronic devices based on organics are often rather flexible and producible in particularly thin layers. The OLED-based screens and displays already available today bear particularly beneficial brilliant colors, contrasts and are comparably efficient with respect to their energy consumption.

Still, there are challenges for generating opto-electronic light-emitting devices. In particular the emitter compounds usable are still improvable. On the one hand, it is desirable to obtain emitter compounds that show beneficial optical properties such as a comparably high illumination level, an emission maximum in the visible range and high quantum yield. On the other hand, the emitter compounds are preferably obtainable in a cost-efficient and energy-efficient way. Further, it is desired to obtain emitter compounds free of toxic and/or rare heavy atoms.

Today, organic emitter compounds with small ΔE(S1-T1) (energy differences between the first excited singlet state S1 and the first excited triplet state T1 of the emitter compound, preferably below 0.2 eV) are known. These emitter compounds typically emit light via a photo-physical mechanism called thermally activated delayed fluorescence (TADF) are known as efficient emitting materials. This enables comparably high quantum yields.

A drawback of many emitter compounds known in the art is their comparably long excited state lifetime of often more than 50 µs and an insufficient reversed-intersystem crossing results in emitters with intense prompt fluorescence and weak TADF. Particularly, materials emitting in the blue range of the visible spectrum exhibit the mentioned drawbacks and represent the bottleneck in OLED development. Opto-electronic devices made from these emitters do not tap into the full theoretical potential of the TADF mechanism, e.g. due to an unsatisfactory efficiency and/or roll-off. It is sometimes noted that the "hole-mobility" in an opto-electronic device is higher than the electron-mobility causing an unbalanced charge recombination in the emissive layer. Also in this context, improved emitter compounds are desired. Further, many of the emitter compounds having suitible optical properties are based on rare metal atoms of which some even bear comparably high toxicity and are cost-efficient and resources-consuming. JP-A 2011-140475 discloses charge transport materials and optical electroluminescent elements, wherein the charge transport materials can bear a silicon atom and a triazine moiety.

In the view of the above, there is still an unmet need for emitter compounds combining beneficial optical properties and cost- and resources-efficiency.

Surprisingly, it has been found that an emitter compound E based on a triazine core, in particular an 1,3.5-triazine, conjugated to at least one phenyl residue bound to a silicon atom and at least one donor moiety Do provides a particularly beneficial emitter compound E bearing high quantum yields and light efficiency in the visible spectrum. The emitter compound E shows comparably high spin-orbit coupling constants.
The highest occupied molecular orbital (HOMO) and lowest unoccupied molecular orbital (LUMO) of the molecules are sufficiently separated to realize a small ΔE(S1 -T1) while still maintaining a high oscillator strength, which typically leads to efficient TADF.

In a first aspect, the present invention relates to emitter compounds E of formula (I) of salts thereof: 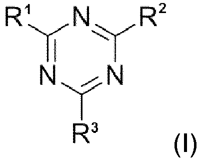 wherein
R¹, R² and R³ are each independently selected from the group consisting of aryl, alkyl-substituted aryl, hydrogen, deuterium, alkyl, heteroaryl, and alkyl-substituted heteroaryl and a moiety of formula (Ia): 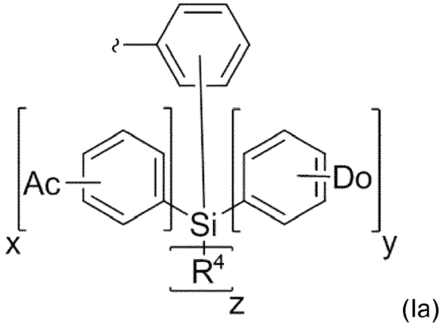 wherein at least one of R¹, R² and R³ is a moiety of formula (Ia); Do represents a donor moiety of formula (Ib): 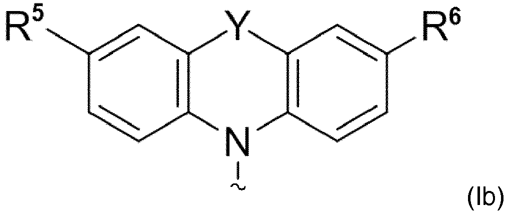 Ac represents an acceptor moiety of the triazine-formula (Ic): 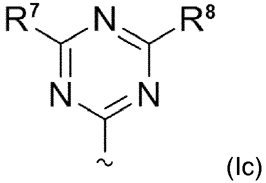
- Y: is independently selected from the group consisting of a single bond, -O-,-S-, -SO-, -SO₂-, -CR⁹R¹⁰, -(CR⁹R¹⁰)(CR¹¹R¹²)- , -(CR⁹)(CR¹⁰)- or 1,2-phenylene;
- R⁴: is independently at each occurrence selected from the group consisting of aryl, alkyl-substituted aryl, alkyl, heteroaryl, and alkyl-substituted heteroaryl;
- R⁵ and R⁶: are each a are each C₁₋₁₀ alkyl, wherein R⁵ = R⁶;
- R⁷ and R⁸: are each independently selected from the group consisting of aryl, alkyl-substituted aryl, hydrogen, deuterium, alkyl, heteroaryl, and alkyl-substituted heteroaryl;
- R⁹, R¹⁰, R¹¹ and R¹²: are each independently selected from the group consisting of hydrogen, deuterium, aryl, alkyl-substituted aryl, alkyl, halogen, heteroaryl, and alkyl-substituted heteroaryl;
- x: is an integer selected from the group consisting of 0, 1 and 2;
- y: is an integer selected from the group consisting of 1, 2 and 3; and
- z: is an integer selected from the group consisting of 2, 1 and 0,
wherein x+y+z = 3.

It is also generally disclosed that R⁵ and R⁶ may be each independently selected from the group consisting of alkyl, hydrogen, deuterium, aryl, alkyl-substituted aryl, -N(aryl)₂, alkyl-substituted -N(aryl)₂, -O-alkyl, -O-aryl, -CF₃, N-carbazoyl, and alkyl-substituted N-carbazoyl.
In accordance with IUPAC nomenclature, it is understood that Si refers to silicon atom and N refers to nitrogen atom.

In the formula, the curly line (∼) at a binding indicates the binding site of the respective moiety to the rest of the molecule. Exemplarily, the curly lines (∼) of the moieties of formulas (Ia) and (Id) indicate the binding sites each to the triazine structure of formula (I). The curly line (∼) of the moiety of formula (Ib) indicates the binding site of the donor moiety Do to the respective phenyl moiety of formula (Ia). The curly line (∼) of the moiety of formula (Ic) indicates the binding site of the acceptor moiety Ac to the respective phenyl moiety of formula (Ia).

The structure of the moiety of formula (Ia) may in one embodiment be depicted as

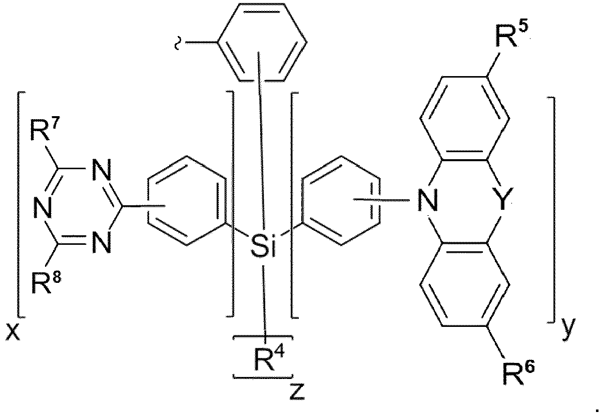

Preferably, the structure of the moiety of formula (Ia) has a structure of formula (Ia1):

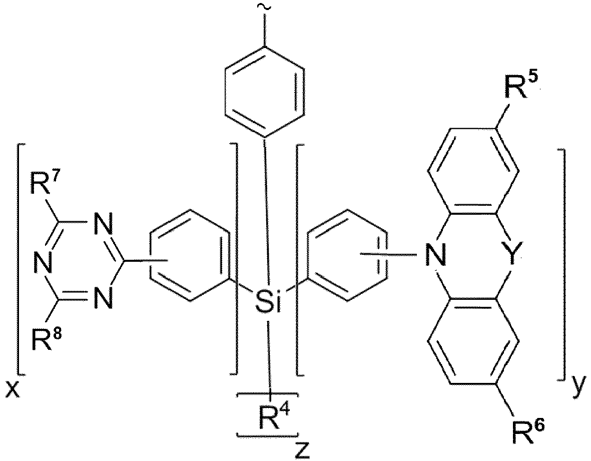

More preferably, the structure of the moiety of formula (Ia) has a structure of formula (Ia2):

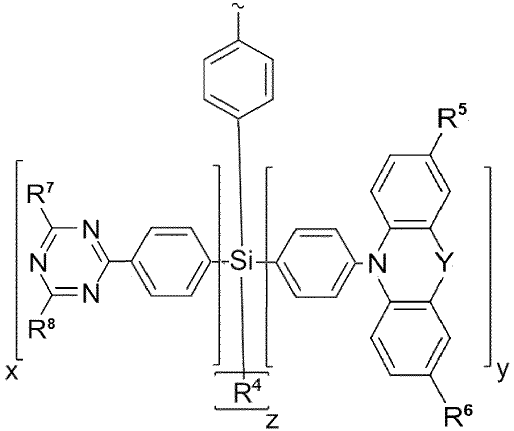

Each donor moiety (Do) and each acceptor moiety (Ac), if present, may be conjugated to the respective phenyl ring in para, meta or ortho position to the bound of Si. Preferably, conjugation of the each donor moiety Do is in para position to the bound of Si. Preferably, conjugation of the each acceptor moiety Ac, if present, is in para position to the bound of Si. More preferably, each donor moiety Do and each acceptor moiety Ac, if present, is conjugated to the respective phenyl ring in para position to the bound of Si.

The person skilled in the art will note that the emitter compounds of the present invention comprise at least one triazine core, suitible to serve as an acceptor moiety Ac and at least one donor moiety Do which is a moiety based on a tricyclic core structure. The emitter compound E of the present invention bears a bipolar structure comprising p-type (donor) and n-type (acceptor) moieties with an interrupted π conjugation between the donor moiety Do and the acceptor moiety Ac.

As used throughout the present application, the terms "aryl" and "aromatic" may be understood interchangeably in the broadest sense as any mono-, bi- or polycyclic aromatic moieties. Exemplarily, an aryl residue may be a phenyl residue. An aryl may also be optionally substituted by one or more substituents, such as, e.g., one or more substituents selected from the group consisting of aryl, alkyl, heteroaryl, heteroalkyl, aralkyl, -O-aryl, -O-alkyl, -O-heteroaryl, -O-heteroalkyl, -O-aralkyl, -N-aryl, -N-alkyl, -N-heteroaryl, -N-heteroalkyl and/or -N-aralkyl of each not having more than 20 carbon atoms and/or halogen. Preferably, an aryl does not comprise more than 20 carbon atoms, in particular not more than 10 carbon atoms, often from 3 to 10. Preferably, the aryl residues are unsubstituted aryl residues, in particular unsubstituted phenyl residues.

As used throughout the present application, the terms "heteroaryl" and "heteroaromatic" may be understood in the broadest sense as any mono-, bi- or polycyclic hetero-aromatic moieties that include at least one heteroatom, in particular which bear from one to three heteroatoms per aromatic ring. Such heteroatom may exemplarily be selected from the group consisting of nitrogen (N), oxygen (O), sulfur (S), and phosphor (P). Exemplarily, a heteroaromatic compound may be pyrrole, furan, thiophene, imidazole, oxazole, thiazole, triazole, pyrazole, pyridine, pyrazine and pyrimidine, and the like. A heteroaryl may also be optionally substituted by one or more substituents, such as, e.g., one or more substituents selected from the group consisting of aryl, alkyl, heteroaryl, heteroalkyl, aralkyl, - O-aryl, -O-alkyl, -O-heteroaryl, -O-heteroalkyl, -O-aralkyl, -N-aryl, -N-alkyl, -N-heteroaryl, -N-heteroalkyl and/or -N-aralkyl of each not more than 20 carbon atoms and/or halogen. Preferably, a heteroaryl does not comprise more than 15 carbon atoms, in particular not more than 10 carbon atoms, often from 3 to 10. Preferably, the heteroaryl residues are unsubstituted heteroaryl residues.

As used throughout the present application, the term "alkyl" may be understood in the broadest sense as a straight, branched chain or cyclic alkyl residue. Preferred alkyl residues are those containing from one to fifteen carbon atoms. Exemplarily, an alkyl residue may be methyl, ethyl, propyl, isopropyl, butyl, isobutyl, tert-butyl, and the like. An alkyl may also be optionally substituted by one or more substituents, such as, e.g., one or more substituents selected from the group consisting of aryl, alkyl, heteroaryl, heteroalkyl, aralkyl, -O-aryl, -O-alkyl, -O-heteroaryl, -O-heteroalkyl, -O-aralkyl, -N-aryl, -N-alkyl, -N-heteroaryl, -N-heteroalkyl and/or -N-aralkyl of each not more than 20 carbon atoms and/or halogen. Preferably, an alkyl does not comprise more than 15 carbon atoms, in particular not more than 10 carbon atoms, often from 3 to 10. Preferably, the alkyl residues are unsubstituted alkyl residues.

As used throughout the present application, the term "heteroalkyl" may be understood in the broadest sense as a straight, branched chain or cyclic alkyl residue wherein one or more carbon atom(s) are replaced by one or more heteroatom(s). A heteroalkyl may also be optionally substituted by one or more substituents, such as, e.g., one or more substituents selected from the group consisting of aryl, alkyl, heteroaryl, heteroalkyl, aralkyl, -O-aryl, -O-alkyl, -O-heteroaryl, -O-heteroalkyl, -O-aralkyl, -N-aryl, -N-alkyl, -N-heteroaryl, -N-heteroalkyl and/or -N-aralkyl of each not more than 20 carbon atoms and/or halogen. Preferably, the heteroalkyl does not comprise more than 15 carbon atoms, in particular not more than 10 carbon atoms, often from 1 to 10. Preferably, the heteroalkyl residues are unsubstituted heteroalkyl residues.

As used throughout the present application, the terms "halogen" and "halo" may be understood in the broadest sense as being preferably fluorine, chlorine, bromine or iodine.

As used throughout the present application, the term "aralkyl" may be understood in the broadest sense as an alkyl residue substituted by an aryl residue. An aralkyl may also be optionally substituted by one or more substituents, such as, e.g., one or more substituents selected from the group consisting of aryl, alkyl, heteroaryl, heteroalkyl, aralkyl, -O-aryl, -O-alkyl, -O-heteroaryl, -O-heteroalkyl, -O-aralkyl, -N-aryl, -N-alkyl, -N-heteroaryl, -N-heteroalkyl and/or -N-aralkyl of each not more than 20 carbon atoms and/or halogen. Preferably, the aralkyl does not comprise more than 15 carbon atoms, in particular not more than 10 carbon atoms, often from 4 to 15. Preferably, the aralkyl residues are unsubstituted aralkyl residues.

As used throughout the present application, the term "alkyl-substituted" may be understood in the broadest sense as the designated residue substituted with one or more straight, branched chain or cyclic alkyl residue(s) as defined above, often with 1 to 10 carbon atoms.

When the emitter compound E is a salt of a structure of formula (I), any ions may be the counter ions. Exemplarily, positively charged counter ions (cations) may be selected from the group consisting of metal ions (e.g., alkali metal ions), (NH₄)⁺, (NR^{ki}₄), (PH₄)⁺, and (PR^{ki}₄)⁺, wherein R^{ki} represents an organic residue selected from the group consisting of an alkyl (e.g., methyl, ethyl, n-propyl, iso-propyl, n-butyl, t-butyl), adamantly, aryl (e.g., phenyl, toloyl, naphtyl, C₆F₅), heteroaryl (e.g., furyl, thienyl, pyridyl, pyrimidyl), alkenyl, alkinyl, methoxyalkyl, tertiary amines.

Exemplarily, negatively charged counter ions (anions) may be selected from the group consisting of PF₆⁻, BF₄⁻, AsF₆⁻, SbF₆⁻, ClO₄⁻, NO₃⁻, BR^{ki}₄⁻, and halogens, wherein R^{ki} is defined as above. Preferably, the counter ions are such usable in a light-emitting layer without disturbing the optical properties of the compound of formula (I), i.e. a counter ion suitible for a light-emitting layer in an opto-electronic device.

In a preferred embodiment, in the emitter compound E of formula (I), Y is a single bond. Then the donor moiety Do of formula (Ic) is an unsubstituted or a substituted carbazoyl residue.

According to the invention, the residues R⁵ and R⁶ are equal (i.e., R⁵ = R⁶). According to the invention, R⁵ and R⁶ are each a C₁₋₁₀ alkyl, in particular are each selected from the group consisting of tert-butyl, isopropyl, ethyl, methyl, n-butyl, and n-propyl.

As defined above, in the emitter compound E of formula (I), the integers x, y and z sum up to three, i.e., x+y+z = 3.

In a preferred embodiment, x = 0. In another preferred embodiment, y = 1. In another preferred embodiment, z = 2.

Exemplarily, in the emitter compound E of formula (I):
(i) x = 0, y = 1, and z = 2;
(ii) x = 0, y = 2, and z = 1;
(iii) x = 0, y = 3, and z = 0;
(iv) x = 1, y = 2, and z = 0;
(v) x = 1, y = 1, and z = 1; or
(v) x = 2, y = 1, and z = 0.

In a highly preferred embodiment, x = 0, y = 1, and z = 2.

Even more preferably, in each moiety of formula (Ia) bound to the structure of formula (I), x = 0, y = 1, and z = 2.

In a preferred embodiment, in the emitter compound E, one of R¹, R² and R³ is a moiety of formula (Ia).

Even more preferably, in the emitter compound E, one of R¹, R² and R³ is a moiety of formula (Ia) and the other two residues of R¹, R² and R³ are each independently selected from the group consisting of aryl, alkyl-substituted aryl, hydrogen, deuterium, alkyl, heteroaryl, and alkyl-substituted heteroaryl, even more preferably are both aryl, in particular are phenyl.

In another preferred embodiment, in the emitter compound E, two of R¹, R² and R³ are each a moiety of formula (Ia).

Even more preferably, in the emitter compound E, two of R¹, R² and R³ are each a moiety of formula (Ia) and the other residue of R¹, R² and R³ is selected from the group consisting of aryl, alkyl-substituted aryl, hydrogen, deuterium, alkyl, heteroaryl, and alkyl-substituted heteroaryl, even more preferably is aryl, in particular is phenyl.

In another preferred embodiment, in the emitter compound E, all three of R¹, R² and R³ are each a moiety of formula (Ia).

As defined above, each Si may also be substituted with R⁴. Preferably, at least one R⁴ is an aryl residue. In a preferred embodiment, each R⁴ is an aryl residue of each not more than 20 carbon atoms.

More preferably, at least one R⁴, in particular each R⁴, is an aryl residue of each not more than 10 carbon atoms. Even more preferably, at least one R⁴ is a phenyl residue. In a particularly preferred embodiment, each R⁴ is a phenyl residue, in particular an unsubstituted phenyl residue.

In a highly preferred embodiment, one, two or three of R¹, R² and R³ each represent a moiety of formula (Id): 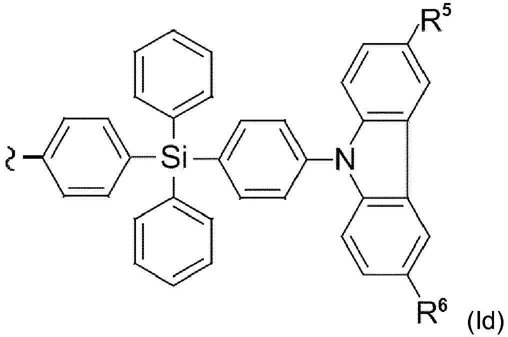 wherein R⁵ and R⁶ are defined as above.

According to the invention, R⁵ = R⁶.

According to the invention, R⁵ and R⁶ are each a C₁₋₁₀ alkyl, in particular are each selected from the group consisting of tert.-butyl, isopropyl, ethyl, methyl, n-butyl, and n-propyl.

Particularly preferably, in the residue of formula (Id), the residues R⁵ and R⁶ are each selected from the group consisting of tert-butyl, isopropyl, ethyl, methyl, n-butyl, and n-propyl.

In a highly preferred embodiment, in the emitter compound E, one of R¹, R² and R³ is a moiety of formula (Id) and the other two residues of R¹, R² and R³ are each independently selected from the group consisting of aryl, alkyl-substituted aryl, hydrogen, deuterium, alkyl, and heteroaryl, even more preferably are both aryl, in particular are phenyl.

In another highly preferred embodiment, in the emitter compound E, two of R¹, R² and R³ are each a moiety of formula (Id) and the other residue of R¹, R² and R³ is selected from the group consisting of aryl, alkyl-substituted aryl, hydrogen, deuterium, alkyl, and heteroaryl, even more preferably is aryl, in particular is phenyl.

In still another highly preferred embodiment, in the emitter compound E, all three of R¹, R² and R³ are each a moiety of formula (Id).

In another preferred embodiment, the emitter compound E of the present invention has the following formula (le): 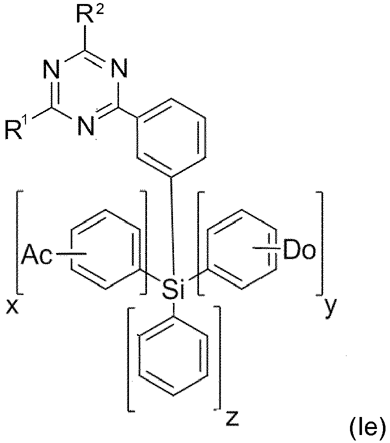 wherein R¹, R², Ac, Do, x, y and z are defined as above, preferably wherein z = 2, y = 1 and x = 0.

In a more preferred embodiment, the emitter compound E of the present invention has the following formula (If): 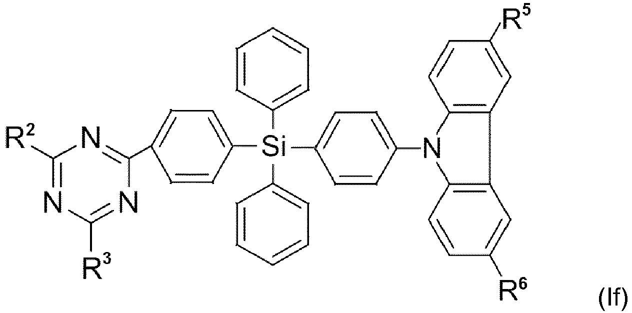 wherein R², R³, R⁵ and R⁶ are defined as above.

Particularly preferably, the emitter compound E has a structure as depicted below or a salt thereof: 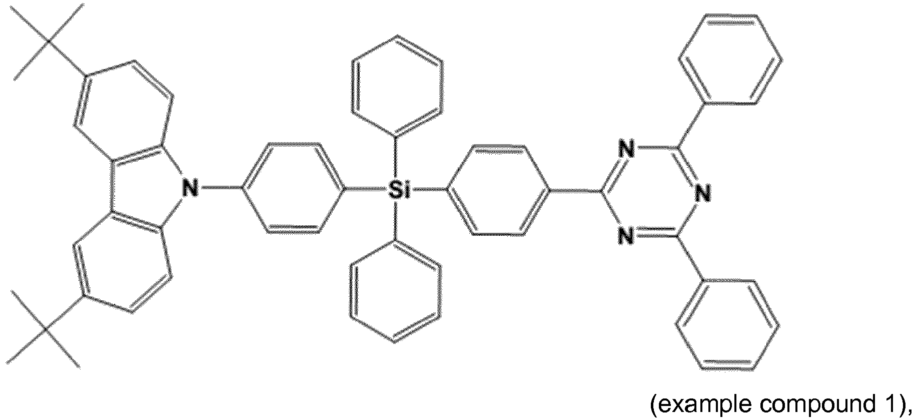 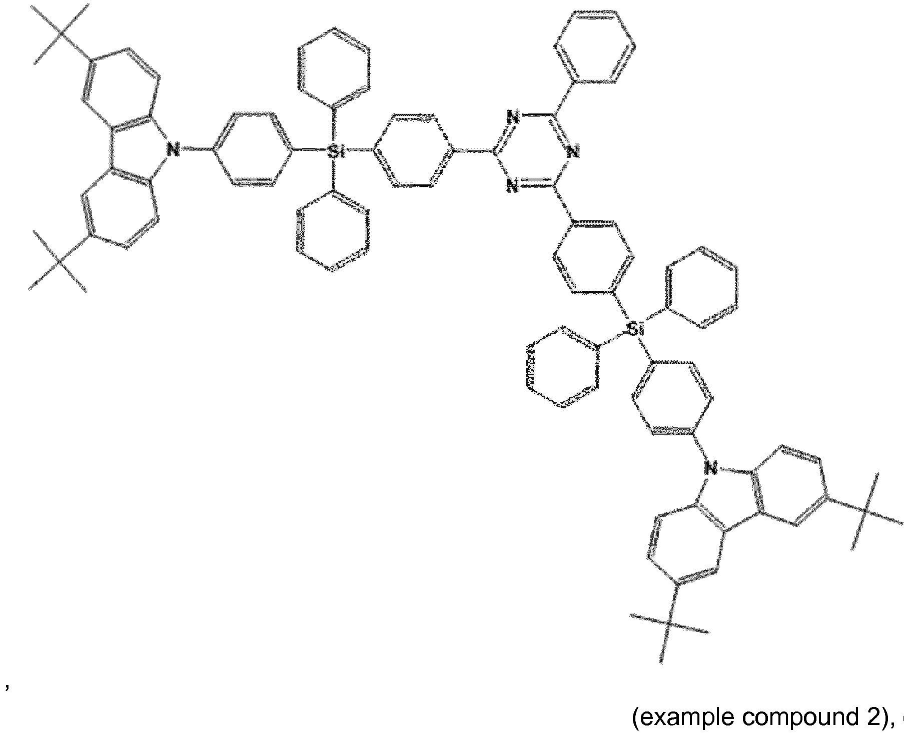 or

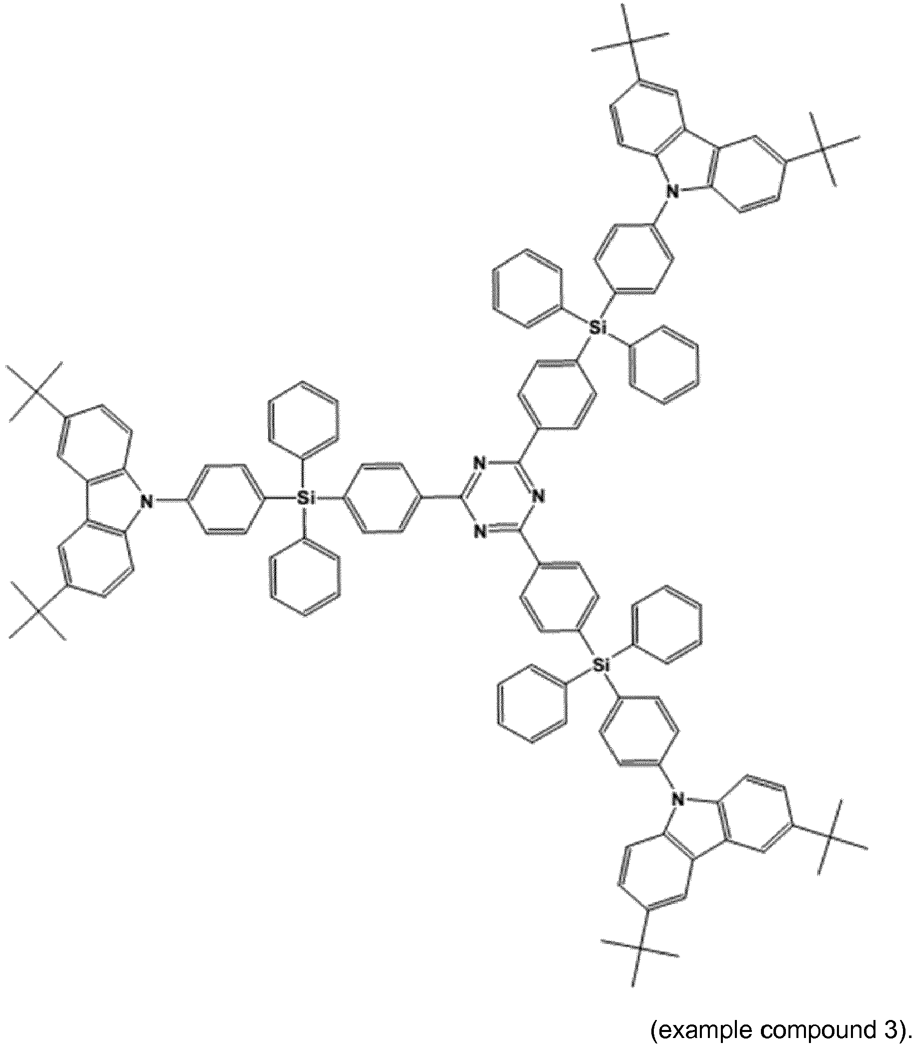

In a preferred embodiment, the emitter compound E of the present invention is a thermally activated delayed fluorescence (TADF) emitter.

In a highly preferred embodiment, the emitter compound E of the present invention bears an energy difference between the first excited singlet state S1 and the first excited triplet state T1 (ΔE(S1-T1)) of not higher than 7000 cm⁻¹, more preferably not higher than 6000 cm⁻¹, even more preferably not higher than 5000 cm⁻¹, even more preferably not higher than 3000 cm⁻¹, even more preferably not higher than 2000 cm⁻¹, even more preferably not higher than 1500 cm⁻¹, in particular not higher than 1000 cm⁻¹.

The emitter compound E of the present invention may be synthesized by any means, exemplarily as depicted in the examples section below.

The emitter compound E of the present invention may also be used to transport or inject charges and thereby helps to transport charges onto the emitting materials. The emitter compound E may also be used to absorb light and thereby convert light energy into electric energy (i.e., separation of charge and/or current flow).

The person skilled in the art knows that emitter compounds are typically usable in light-emitting layers, exemplarily usable in opto-electronic devices.

Therefore, a further aspect of the present invention relates to a light-emitting layer B comprising:
(a) at least one emitter compound E of the present invention; and
(b) optionally, one or more host components (c), one or more dyes and/or one or more solvents.

In the context of the present invention, a light-emitting layer B may be understood in the broadest sense as any optically active layer that is, depending on certain conditions, able to emit light when introduced in an opto-electronic device.

Accordingly, the light-emitting layer B may be used to generate light. For generating light, the light-emitting layer B is typically incorporated into an opto-electronic device. Then, electrical or chemical energy is fed to such device. Preferably, an electrical current flow is led through the opto-electronic device OD and thereby through the light-emitting layer B incorporated therein. Thereby, the electrical current flow excites the emitter compound E of the present invention leading to excitons (i.e., one or more excited state(s) such S1 and/or T1 and optionally also higher energy level(s) such as, e.g., S2 etc.) that may relax into the basic energy level corresponding to the respective non-exited state S0 by concomitantly emitting light. The energy of the exciton may optionally also be transferred into other excited states.

The light-emitting layer B may, however, under certain circumstances, also be used to absorb light and thereby convert light energy into electric energy (i.e., separation of charge and/or current flow).

Preferably, the light-emitting layer B may comprise both inorganic compounds and organic components, i.e., hydrocarbons which may optionally also comprise heteroatoms such as, e.g., nitrogen, oxygen, phosphor and/or sulfur as substituents. Optionally, the light-emitting layer B may also be (mainly) composed of organic components.

The content of the emitter compound E in the light-emitting layer B may be in the range of from 0.1 to 100 % (w/w). Therefore, the light-emitting layer B may be essentially composed of emitter compounds of the present invention or may merely comprise a small or larger proportion thereof. In some opto-electronic devices, such as LECs, the content of the emitter compounds in the light-emitting layer B may optionally be larger than 30% (w/w), larger than 40% (w/w), larger than 50% (w/w), larger than 60% (w/w), larger than 70% (w/w), larger than 80% (w/w), or even larger than 90% (w/w).

The term "layer" as used in the context of the present invention preferably is a body that bears an extensively planar geometry. The light-emitting layer B preferably bears a thickness of not more than 1 mm, more preferably not more than 0.1 mm, even more preferably not more than 10 µm, even more preferably not more than 1 µm, in particular not more than 0.1 µm.

Unless otherwise specified, any of the layers of the various embodiments may be deposited by any suitable method. The layers in the context of the present invention, including the light-emitting layer B, may optionally be prepared by means of liquid processing (also designated as "film processing", "fluid processing", solution processing or "solvent processing"). This means that the components comprised in the respective layer are applied to the surface of a part of a device in liquid state. Preferably, the layers in the context of the present invention, including the light-emitting layer B, may be prepared by means of spin-coating. This method well-known to those skilled in the art allows obtaining thin and (essentially) homogeneous layers.

Preferably, the emitter compound E of the present invention is doped into one or more appropriate host components (c) to prevent the triplet-triplet annihilation and the concentration quenching. The one or more host component(s) (c) as optionally comprised in the light-emitting layer may be any host component(s) known in the art. Exemplarily, a host may bear a polymeric structure. A host component may preferably be able to adjust the spatially distances between the emitter compounds. The spatial distance between two emitter compounds should not be too small in order to prevent self-quenching and triplett-triplett annihilation (TTA). Further, the one or more host component(s) (c) may optionally improve conductibility of the light-emitting layer B. This may improve the brightness obtainable by the opto-electronic device OD comprising such light-emitting layer B even further. Moreover, the one or more host component(s) (c) may optionally also serve as energy-providing source for exciting one or both emitter compound E(s).

Preferably, host components (c) may have large band gaps, enough for effective electron or energy transfer to the emitter compounds. To obtain a high efficiency from the opto-electronic device OD, these host components (c) preferably bear one or more, preferably all of the subsequent properties:
(a) The triplet energy of the host component(s) (c) may be higher than the triplet energy of the emitter compound E (in this way, back energy / electron transfer from the emitter compound E to host component(s) (c) can preferably be (essentially) prevented);
(b) The host component(s) (c) may have a high glass transition temperature to obtain an amorphous thin film (in this way, the concentration quenching can preferably be minimized due to the uniform dispersion of the emitter compound E in the host component(s) (c)); and
(c) A balanced charge flux within the emissive layer may be provided. Many of the reported host components (c) known in the art are p-type and may therefore be favorable for the hole transport in the opto-electronic device OD.

Therefore, the "hole-mobility" in the opto-electronic device OD may become higher than the electron mobility what may cause an unbalanced charge recombination in the emissive layer.

Alternatively, the layers in the context of the present invention, including the light-emitting layer B, may be prepared by other methods based on liquid processing such as, e.g., casting (e.g. dropcasting) and rolling methods, and printing methods (e.g., inkjet printing, gravure printing, blade coating). This may optionally be carried out in an inert atmosphere (e.g. in a nitrogen atmosphere).

Alternatively, the layers in the context of the present invention, including the light-emitting layer B, may be prepared by any other method known in the art, including but not limited to vacuum processing methods well-known to those skilled in the art such as, e.g., thermal evaporation, organic vapor phase deposition (OVPD), and deposition by organic vapor jet printing (OVJP).

When preparing layers by means of liquid processing, the solutions including the components of the layers (i.e., with respect to the light-emitting layer B, the emitter compound E of the present invention and, optionally, one or more host component(s) (c) may further comprise a volatile organic solvent. Such volatile organic solvent may optionally be one selected from the group consisting of tetrahydrofuran, dioxane, chlorobenzene, diethylene glycol diethyl ether, 2-(2-Ethoxyethoxy)ethanol, gamma-butyrolactone, N-methyl pyrollidinon, ethoxyethanol, xylene, toluene, anisole, phenetol, acetonitrile, tetrahydrothiophene, benzonitrile, pyridine, trihydrofuran, triarylamine, cyclohexanone, acetone, propylene carbonate, ethyl acetate, benzene, (2-methyltetrahydrofuran (2-MeTHF), Dichloromethane (DCM), and PGMEA (propylen glycol monoethyl ether acetate).

Also a combination of two or more solvents may be used. In order to improve the flow properties, one or more additive(s) may optionally be added. Exemplarily, such an additives may be selected from the group consisting of polyethyloxides (polyethylene glycols), polyethylene diamines, polyacrylates (e.g., poly(methyl methacrylate) (PMMA), polyacrylic acid and salts thereof (superabsorber)), substituted or unsubstituted polystyrenes (e.g., polyhydroxystyrene), polyvinylalcohols, Polyesters or polyurethanes, polyvinylcarbazoles, polytriaryamines, polythiophenes and poly(vinylidene phenylenes). Also a combination of two or more additives may be used. After applied in liquid state, the layer may subsequently be dried and/or hardened by any means of the art, exemplarily at ambient conditions, at increased temperature (e.g., about 50°C or about 60°C) or at diminished pressure.

Optionally, the light-emitting layer B may also comprise fluorescent polymers (e.g., superyellow (SY)), photoluminescent nanoparticles (e.g., quantum dots, cadmium selenide and/or exciplexes, optionally diluted with one or more host component(s) (c).

In order to modify the emission spectrum and/or the absorption spectrum of the light-emitting layer B further, the light-emitting layer B may further comprise one or more dye(s). Such dye may be any dye known in the art. The dye may optionally be a fluorescent and/or phosphorescent dye which is able to shift the emission spectrum and/or the absorption spectrum of the light-emitting layer B. Optionally, the light-emitting layer B may also provoke two-photon effects (i.e., the absorption of two photons of half the energy of the absorption maximum). Typically, when using a fluorescent and/or phosphorescent dye, a bathochromer shift of the emission spectrum is achieved (exemplarily due to thermal loss). By means of a two-photon effect, also hypsochromer shifting may be achieved.

The light-emitting layer B may also (in particular when it is intended for a light-emitting electrochemical cell (LEC)) comprise an ionic fluid or a combination of two or more ionic liquids. Exemplarily, such ionic fluid may be such selected from the group consisting of: methylimidazolium hexafluorophosphates (e.g., 1-alkyl-3-methylimidazolium hexafluorophosphate such as 1-methyl-3-methylimidazolium hexafluorophosphat, 1-ethyl-3-methylimidazolium hexafluorophosphate, 1-propyl-3-methylimidazolium hexafluorophosphate, 1-butyl-3-methylimidazolium hexafluorophosphate, 1-benzyl-3-methylimidazolinium hexafluorophosphate), dimethylimidazolium hexafluorophosphates (e.g., 1-alkyl-2,3-dimethylimidazolium hexafluorophosphate such as 1-butyl-2,3-dimethylimidazolium hexafluorophosphat), 3-methylimidazolium hexafluorophosphates (e.g., 1-alkyl-methylimidazolium hexafluorophosphates such as 1-methyl-3-methylimidazolium hexafluorophosphate, 1-ethyl-3-methylimidazolium hexafluorophosphate, 1-propyl-3-methylimidazolium hexafluorophosphate, 1-butyl-3-methylimidazolium hexafluorophosphate, 1-pentyl-3-methylimidazolium hexafluorophosphate, 1-hexyl-3-methylimidazolium hexafluorophosphate), 1-butyl-1-(3,3,4,4,5,5,6,6,7,7,8,8,8-tridecafluorooctyl)imidazolium hexafluorophosphate, 1-methyl-3-(3,3,4,4,5,5,6,6,7,7,8,8,8-tridecafluorooctyl)imidazolium hexafluorophosphate, 1-methyl-3-octylimidazolium hexafluorophosphate, methylimidazolium tetrafluoroborates (e.g., 1,3-dimethylimidazolium tetrafluoroborate, 1-ethyl-3-methyl-imidazolium tetrafluoroborate, 1-propyl-3-methylimidazolium tetrafluoroborate, 1-butyl-3-methyl-imidazolium tetrafluoroborate), 1-butyl-2,3-dimethylimidazolium tetrafluoroborate, 1-hexyl-3-methylimidazolium tetrafluoroborate, 1-methyl-3-octyl-imidazolium tetrafluoroborate, methylimidazolium trifluoromethanesulfonates (e.g., 1-methyl-3-methylimidazolium trifluoromethanesulfonate, 1-ethyl-3-methylimidazolium trifluoromethanesulfonate, 1-propyl-3-methylimidazolium trifluoromethanesulfonate, 1-butyl-3-methylimidazolium trifluoromethanesulfonate), 1,2,3-trimethylimidazolium trifluoromethanesulfonate, 1-ethyl-3-methylimidazolium bis(pentafluoroethylsulfonyl)imide, 1-butyl-3-methylimidazolium bis(trifluoromethylsulfonyl)imide, 1-butyl-3-methylimidazolium methanesulfonate, Tetrabutylammonium bis-trifluoromethane sulfonimidate, Tetrabutylammonium methane sulfonate, Tetrabutylammonium nonafluorobutane sulfonate, Tetrabutylammonium heptadecafluorooctane sulfonate, tetrahexylammonium tetrafluoroborate, Tetrabutylammonium trifluoromethanesulfonate, tetrabutylammoniumbenzoate, Tetrabutylammonium halogenide (e.g., tetrabutylammoniumchloride, Tetrabutylammoniumbromide), 1-benzyl-3-methylimidazolium tetrafluoroborate, trihexyl-tetradecylphosphonium hexafluorophosphate, tetrabutyl-phosphonium methanesulfonate,tetrabutyl-phosphonium tetrafluoroborate, tetrabutyl-phosphoniumbromide,1 -butyl-3-methylpyridinium-bis(trifluormethylsulfonyl)imide, 1-butyl-4-methylpyridinium hexafluorophosphate, 1-butyl-4-methylpyridinium tetrafluoroborate, sodium tetraphenylborate, tetrabutylammonium tetraphenylborate, sodiumtetrakis(1-imidazolyl)borate and cesium tetraphenylborate.

Additionally or alternatively, the emitter layer may comprise one or more electrolyte(s) such as, e.g., KCF₃SO₃, LiF₃SO₃, poly(ethylene oxide), (polyethylene oxide)dimethyl acrylate, trimethylolpropane ethyoxylate.

The emitter compounds of the present invention may be used in conjunction with a wide variety of hosts, transport layers, blocking layers, injection layers, electrodes and other layers that may be present (e.g., as dopants). The materials described herein are merely non-limiting examples of materials that may be useful in combination with the emitter compound E of the present invention and components disclosed herein, and those skilled in the art are readily able to consult the literature to identify other materials that may be useful in combination herewith.

Optionally, the light-emitting layer B may also comprise one or more of the following compounds selected from the group consisting of an aromatic compound (e.g., benzene, biphenyl, triphenyl, triphenylene, naphthalene, anthracene, phenalene, phenanthrene, fluorene, pyrene, chrysene, perylene, azulene), an heteroaromatic compound (e.g., dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, selenophenodipyridine). Optionally, two or more of these structures may also be conjugated with another either directly or, e.g., via at least one of oxygen atom, nitrogen atom, sulfur atom, silicon atom, phosphorus atom, boron atom, or an optionally substituted hetero(alkylene), hetero(alkenylene), hetero(alkinylene) or (hetero)arylene residue. Herein each residue may optionally be substituted by a substituent selected from the group consisting of deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

As described herein, a light-emitting layer B of the present invention may be used in an opto-electronic device OD.

Therefore, a further aspect of the present invention refers to an opto-electronic device OD comprising a light-emitting layer B of the present invention.

Optionally, the whole opto-electronic device OD is mainly composed of organic components, i.e., hydrocarbons which may optionally also comprise heteroatoms such as, e.g., nitrogen, oxygen, phosphor and/or sulfur as substituents. Optionally, the opto-electronic device OD may also comprise inorganic compounds.

The opto-electronic device OD may be intransparent, semi-transparent or (essentially) transparent.

The opto-electronic device OD as a whole may optionally form a thin layer of a thickness of not more than 5 mm, more than 2 mm, more than 1 mm, more than 0,5 mm, more than 0,25 mm, more than 100 µm, or more than 10 µm. The opto-electronic device OD may optionally have a thickness in the range of 8-9 µm, 7-8 µm, 6-7 µm, 5-6 µm, 4-5 µm, 3-4 µm, 2-3 µm, 1-2 µm or less than 1 µm.

The opto-electronic device OD may be any opto-electronic device comprising the light-emitting layer B according to the present invention.

In a preferred embodiment, the opto-electronic device OD is a device selected from the group consisting of an organic light emitting diode (OLED), a light emitting electrochemical cell (LEC), a transistor, a light-emitting transistor, an organic solar cell (OSC), and an optical sensor.

Particularly preferably, the opto-electronic device OD is an organic light emitting diode (OLED).

The opto-electronic device OD may have any set-up. In a preferred embodiment, the opto-electronic device OD of the present invention comprises at least the layers:
(A) an anode layer A, preferably comprising indium tin oxide, indium zinc oxide, PbO, SnO, graphite, doped silicium, doped germanium, doped GaAs, doped polyaniline, doped polypyrrole and/or doped polythiophene;
(B) a light-emitting layer B of the present invention (comprising the emitter compound E); and
(C) a cathode layer C, preferably comprising Al, Au, Ag, Pt, Cu, Zn, Ni, Fe, Pb, In, W, Pd, LiF, Ca, Ba, Mg, and/or mixtures or alloys of two or more thereof.

Preferably, the order of the layers herein is (A) - (B) - (C), thus the light-emitting layer B is located between the anode layer A and the cathode layer C. This does, of course, not exclude that optionally further layers are comprised between those layers therein.
Exemplarily, when the opto-electronic device OD is an OLED, it may optionally comprise the following layer structure:
(A) an anode layer A, preferably comprising indium tin oxide (ITO);
   (HTL) a hole transport layer HTL;
(B) a light-emitting layer B according to the present invention as described
   herein;
   (ETL) an electron transport layer ETL; and
(C) a cathode layer, preferably comprising Al, Ca and/or Mg.

Preferably, the order of the layers herein is (A) - (HTL) - (B) - (ETL) - (C).

Furthermore, the opto-electronic device OD may optionally comprise one or more protective layers protecting the device from damaging exposure to harmful species in the environment including, exemplarily moisture, vapor and/or gases.

The light-emitting layer B may further fulfill other purposes in an opto-electronic device OD it is introduced in. This may depend on the properties of the opto-electronic device OD, which is particularly preferably an organic light-emitting diode (OLED). The light-emitting layer B may concomitantly have a functionality selected from the group consisting of: an electron transport layer, a hole blocking layer, a hole transport layer and an electron blocking layer.

It is well-known by those skilled in the art that OLEDs are typically composed of several layers. Mostly, an anode layer A is located on the surface of a substrate. The substrate may be formed by any material or composition of materials. Most frequently, glass slides are used as substrates. Alternatively, thin metal layers (e.g., copper, gold, silver or aluminium films) or plastic films or slides may be used. This may allow a higher degree of flexibility.

The anode layer A is typically mainly composed of materials allowing to obtain an (essentially) transparent film. As at least one of both electrodes should be (essentials) transparent in order to allow light emission from the OLED, either the anode layer A or the cathode layer C transparent. Preferably, the anode layer A comprises a large content or even consists of transparent conductive oxides (TCOs). Such anode layer A may exemplarily comprise indium tin oxide, aluminium zinc oxide, fluor tin oxide, indium zinc oxide, PbO, SnO, zirconium oxide, molybdenum oxide, vanadium oxide, wolfram oxide, graphite, doped Si, doped Ge, doped GaAs, doped polyaniline, doped polypyrrol and/or doped polythiophene. Particularly preferably, the anode layer A (essentially) consists of indium tin oxide (ITO) (typically (InO₃)_{0.9}(SnO₂)_{0.1}).

The roughness of the anode layer A caused by the transparent conductive oxides (TCOs) may be compensated by using a hole injection layer (HIL). Further, the HIL may facilitate the injection of quasi charge carriers (i.e., holes) in that the transport of the quasi charge carriers from the TCO to the hole transport layer (HTL) is facilitated. The hole injection layer (HIL) may comprise poly-3,4-ethylendioxy thiophene (PEDOT), polystyrene sulfonate (PSS), MoO₂, V₂O₅, CuPC or Cul, in particular a mixture of PEDOT and PSS. The hole injection layer (HIL) may also prevent the diffusion of metals from the anode layer A into the hole transport layer (HTL).

Adjacent to the anode layer A or hole injection layer (HIL) typically a hole transport layer (HTL) is located. Herein, any hole transport compound may be used. Exemplarily, electron-rich heteroaromatic compounds such as triarylamines and/or carbazoles may be used as hole transport compound.

The HTL may decrease the energy barrier between the anode layer A and the light-emitting layer B (serving as emitting layer (EML)). The hole transport layer (HTL) may also be an electron blocking layer (EBL). Preferably, hole transport compounds bear comparably high energy levels of their triplet states T1. Exemplarily the hole transport layer (HTL) may comprise a star-shaped heterocycle such as tris(4-carbazoyl-9-ylphenyl)amine (TCTA).

Adjacent to the hole transport layer (HTL), typically the light-emitting layer B is located. This is specified in detail in the context of the present invention.

Adjacent to the light-emitting layer B an electron transport layer (ETL) may be located. Herein, any electron transporter may be used. Exemplarily, compounds poor of electrons such as, e.g., benzimidazoles, pyridines, triazoles, oxadiazoles (e.g., 1,3,4-oxadiazole), phosphinoxides and sulfone, may be used. Exemplarily, an electron transporter may also be a star-shaped heterocycle such as 1,3,5-tri(1-phenyl-1H-benzo[d]imidazol-2-yl)phenyl (TPBi). The electron transport layer (ETL) may also block holes.

Adjacent to the electron transport layer (ETL), a cathode layer C may be located. Exemplarily, the cathode layer C may comprise or may consist of a metal (e.g., Al, Au, Ag, Pt, Cu, Zn, Ni, Fe, Pb, LiF, Ca, Ba, Mg, In, W, or Pd) or a metal alloy. For practical reasons, the cathode layer may also consist of (essentially) intransparent metals such as Mg, Ca or Al. Alternatively or additionally, the cathode layer C may also comprise graphite and or carbon nanotubes (CNTs). Alternatively, the cathode layer C may also consist of nanoscalic silver wires.

An OLED may further, optionally, comprise a protection layer between the electron transport layer (ETL) and the cathode layer C (which may be designated as electron injection layer (EIL)). This layer may comprise lithium fluoride, cesium fluoride and/or silver.

Next to the common uses, OLEDs may exemplarily also be used as luminescent films, "smart packaging" labels, or innovative design elements. Further they are usable for cell detection and examination (e.g., as bio labelling). An OLED according to the present invention may also be used as large-area illuminating device, as luminescent wallpaper, luminescent window frame or glass, luminescent label, luminescent poser or flexible screen or display.

In the OLED, electrodes migrate from the cathode layer C to the anode layer A. Holes and electrons fuse in the light-emitting layer B and concomitantly form excited states of the emitter compound (excitons).

An OLED may exemplarily be an essentially white OLED that may comprise at least one deep blue emitter compound E and one or more emitter compound E(s) emitting green and/or red light. Then, there may also be energy transmittance between two or more compounds as described above.

In an organic solar cell (OSC), the content of the emitter compound E in the light-emitting layer B (serving as absorber layer) is preferably between 30 and 100 % (w/w). Like in an OLED, also an OSC comprises two electrodes. The light-emitting layer B (serving as absorber layer) is located in between the two electrodes. As mentioned above, the emitter compound E may also serve as a light-absorbing compound. The layers comprised in an OSC are similar to those described above and well-known to those skilled in the art. A single-layer OSC is typically mounted on a substrate. A multilayer OSC may exemplarily be composed similar to an OLED. An OSC according to the present invention may also be used as flexible and optionally even rollable solar cell (e.g., for smartphones, laptops, tablets, etc.), as architectural item (e.g., as a part for covering a wall or a roof), or a functional component of vehicles (e.g., automobiles, plains, railways, and/or ships). Such products comprising an opto-electronic device OD according to the present invention are also embraced by the present invention.

An optical sensor may be a sensor determining the light intensity either unspecifically or wavelength-specific. It may also form a part of an array of sensors such as, e.g., an image sensor usable in a digital camera.

As indicated above, the present invention also refers to the generation of light by means of an opto-electronic device OD of the present invention.

Therefore, a still further aspect of the present invention relates to a method for generating light of a desired wavelength range, comprising the steps of:
(i) providing an opto-electronic device OD of the present invention; and
(ii) lead an electrical current flow through the light-emitting layer B comprised in the opto-electronic device OD.

The generated light of a desired wavelength range preferably is light in the visible range, i.e., light in the range of from 380 nm-800 nm. Preferably, the emitter compound E of the present invention also shows an emission maximum in the visible range.

The visible range comprises the following color ranges of which one or more may be emitted by the emitter compound E of the present invention:
violet: wavelength range of >380-420 nm;
blue: wavelength range of >420-485 nm;
green:wavelength range of >485-560 nm;
yellow: wavelength range of >560-580 nm;
orange: wavelength range of >580-620 nm; and/or
red: wavelength range of >620-800 nm.

Accordingly, the present invention also relates to a method for generating violet, blue, green, yellow, orange or red light.

In a preferred embodiment, the generated light has an emission maximum in the range of from 380 to 575 nm, particularly preferred in the range of >420-485 nm.

Therefore, then, the emitted light may be violet, blue, green and/or yellow light. In a particularly preferred embodiment the emitted light may be blue light.

The Figures and Examples shown below further exemplify the invention, but are not intended to limit the scope thereof.

### Brief Description of the Figures

**Figure 1** depicts the emission spectrum of example compound 1 in solution at room temperature (2-methyltetrahydrofuran (2-MeTHF), 10⁻² M, excited at 300 nm).
**Figure 2** depicts the emission spectrum of example compound 1 in cold solution at 77 K (2-MeTHF, 10⁻² M, excited at 300 nm).
**Figure 3** depicts the excitation spectrum of example compound 1 in solution (2-MeTHF, 10⁻² M, room temperature, observed emission at 480 nm).
**Figure 4** depicts the emission spectrum of example compound 1 in a poly(methyl methacrylate) (PMMA) film (10 w-% doping concentration, room temperature, excited at 300 nm).
**Figure 5** depicts the UV-Vis absorption spectra of the synthesized molecules (10⁻⁵ M) of example compound 1 (Fig. 5A) and example compound 2 (Fig. 5B) in various solvents.
**Figure 6** depicts the .photoluminescence (PL) spectra of the synthesized molecules (10⁻⁵ M) of example compound 1 (Fig. 6A) and example compound 2 (Fig. 6B) in various solvents excited at λ_{exc} = 296 nm.
**Figure 7** depicts the phosphorescence spectra of the synthesized molecules (10⁻⁵ M) of example compound 1 (Fig. 7A) and example compound 2 (Fig. 7B) measured at 77K in 2-MeTHF, excited at λ_{exc} = 296 nm.
**Figure 8** depicts cyclic voltammetry results of the synthesized molecules measured in dichloromethane (DCM).
**Figure 9** depicts the UV-Vis absorption spectra of the example compound 1, non-doped (spin coated from toluene solution, 10 mg/ml) (Fig. 9A) and doped with bis[2-(4,6-difluorophenyl)pyridinato-C2,N](picolinato)iridium(III) (Flrpic) (Fig. 9B) in the film phase (15 w-% doping concentration, room temperature).
**Figure 10** depicts the UV-Vis absorption spectra of the example compound 2, non-doped (spin coated from toluene solution, 10 mg/ml) (Fig. 10A) and doped with bis[2-(4,6-difluorophenyl)pyridinato-C2,N](picolinato)iridium(III) (FIrpic) (Fig. 9B) in the film phase (15 w-% doping concentration, room temperature, spin coated from toluene solution, total concentration of 10 mg/ml).
**Figure 11** depicts the photoluminescence (PL) spectra of the example compound 1, non-doped (spin coated from toluene solution, 10 mg/ml) (Fig. 11A) and doped with bis[2-(4,6-difluorophenyl)pyridinato-C2,N](picolinato)iridium(III) (FIrpic) (Fig. 11B) in the film phase (15 w-% doping concentration, room temperature, spin coated from toluene solution, total concentration of 10 mg/ml, excited at 300 nm).
**Figure 12** depicts the photoluminescence (PL) spectra of the example compound 2, non-doped (spin coated from toluene solution, 10 mg/ml) (Fig. 12A) and doped with bis[2-(4,6-difluorophenyl)pyridinato-C2,N](picolinato)iridium(III) (FIrpic) (Fig. 12B) in the film phase (15 w-% doping concentration, room temperature, spin coated from toluene solution, total concentration of 10 mg/ml, excited at 300 nm).
**Figure 13** depicts the HOMO distribution (Fig 13A) and the LUMO distribution (Fig 13B) of the example compound 1.

### Examples

### Synthesis of the bipolar host materials

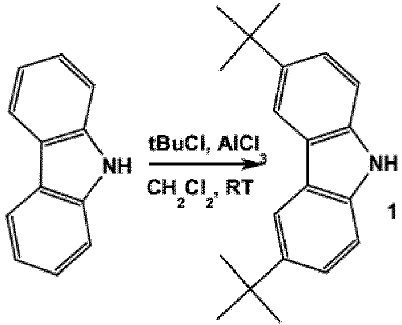

3,6-di-tert-butyl-9H-carbazole (1): Carbazole (15 mmol, 2.5 g) was dissolved in 50 mL DCM and AlCl₃ (15 mmol, 2 g) was added to the stirring solution. The resultant solution was cooled with an ice-water bath and tert-butyl chloride (t-BuCl) (30 mmol, 3.3 mL) was added dropwise. The solution was left for stirring at RT for overnight. Water was added to the reaction mixture and DCM phase was separated. Organic phase was dried over MgSO₄, and solvents were removed on rotary evaporator. The crude product was recrystallized from the petroleum ether. Yield: %54.
IR (500-4000 cm⁻¹, KBr pellet): 3415, 2958, 2903, 2864, 1493, 1471, 1392, 1363, 1300, 1264, 1250, 820, 617. ¹H-NMR (*δ_{H}, ppm,* 400 MHz, CDCl₃): 8.07 (s, 2H, Ar); 7.66 (s, 1H, N-H); 7.47-7.42 (d, 2H, Ar); 7.25-7.22 (d, 2H, Ar); 1.44 (s, 18H). ¹³C-NMR (δH, ppm, 400 MHz, CDCl₃): 142.49; 138.29; 123.76; 123.56; 116.40; 110.30; 34.96; 32.31.

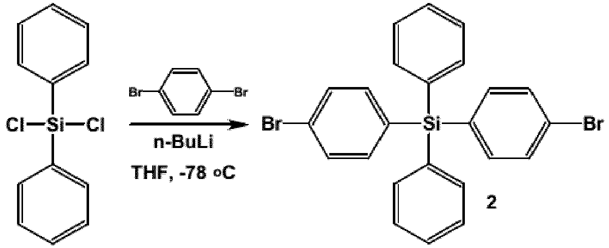

Bis(4-bromophenyl)(diphenyl)silane (2): 1,4-dibromobenzene (40 mmol, 9.44 g) was weighed into the Schlenk and dried under vacuum. 100 mL THF was added to the reaction flask and the resultant solution was cooled down to -78 °C by using dry ice/acetone mixture. n-BuLi (2,5 M, 42 mmol, 16.8 mL) was added to the reaction flask dropwise and the resultant solution was stirred at -78 °C for about 2 hours. Dichlorodiphenylsilane (20 mmol, 4.20 mL) was added to the reaction flask dropwise and the resultant solution was stirred at RT for overnight. Water (60 mL) was added to quench the reaction and THF phase was separated. Water phase was washed with 2x50 mL DCM, organic solvents were combined and dried over MgSO₄ and solvents evaporated on the rotary evaporator. The crude product was precipitated from EtOH/DCM mixture and white solid was obtained. Yield: % 51
IR (500-4000 cm⁻¹, KBr pellet): 3065, 3024, 1567, 1549, 1477, 1428, 1376, 1301, 1183, 1111, 1062, 1008, 998, 809, 728, 711, 698, 537, 522, 512. ¹H-NMR (δH, ppm, 400 MHz, CDCl₃): 7.60-7.52 (m, 8H, Ar); 7.47-7.35 (m, 10H, Ar). ¹³C-NMR (δH, ppm, 400 MHz, CDCl₃): 138.07; 136.47; 133.27; 132.93; 131.47; 130.25; 128.36; 125.23.

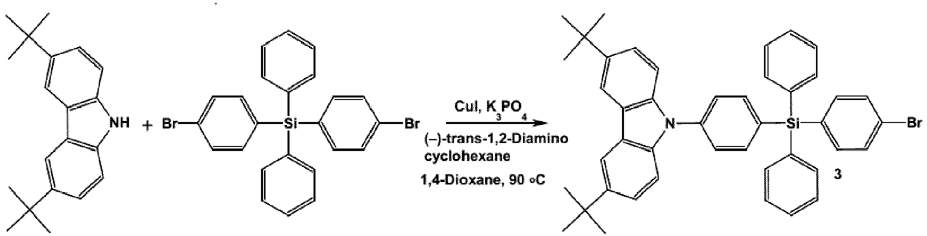

9-{4-[(4-bromophenyl)(diphenyl)silyl]phenyl}-3,6-di-*tert*-butyl-9*H*-carbazole (3): 3,6-di-tert-butyl-9H-carbazole (5 mmol, 1.40 g), bis(4-bromophenyl)(diphenyl)silane (7 mmol, 3.46 g), Cul (1 mmol, 0.19 g) and K₃PO₄ (10 mmol, 2.12 g) was weighed to the reaction flask. 1,4-dioxane (20 mL) was added to the reaction flask and the resultant mixture was stirred at RT for about 5-10 minutes. (±)-*trans*-1,2-Diaminocyclohexane (2 mmol, 0.24 mL) was added to the reaction flask and the mixture was heated to 90 °C for overnight. The crude product was filtered through a short silica column and non-dissolved solid materials were removed. The white solid was obtained after the column chromatography with cyclohexane/DCM (10/1) solvent system. Yield: % 49
IR (500-4000 cm⁻¹, KBr pellet): 3039, 3007, 2952, 2861, 1589, 1570, 1505, 1487, 1471, 1376, 1362, 1294, 1260, 1232, 1109, 1066, 1010, 881, 808, 739, 727, 705, 540, 524, 515. ¹H-NMR (δH, ppm, 400 MHz, CDCl₃): 8.08-8.04 (d, 2H, Ar); 7.70-7.64 (d, 2H, Ar); 7.58-7.46 (m, 8H, Ar); 7.44-7.32 (m, 12H, Ar); 1.42-1.36 (s, 18H). ¹³C-NMR (δH, ppm, 400 MHz, CDCl₃): 143.34; 140.02; 139.16; 138.21; 137.94; 136.59; 133.66; 133.32; 132.40; 131.50; 130.25; 128.38; 126.05; 125.20; 123.84; 116.59; 116.41; 109.60; 34.97; 32.17.

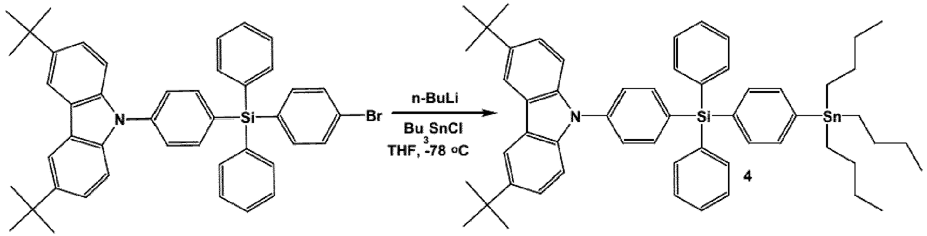

### 3,6-di-tert-butyl-9-(4-{diphenyl[4-(tributylstannyl)phenyl]silyl}phenyl)-9H-carbazole (4):

A 9-{4-[(4-bromophenyl)(diphenyl)silyl]phenyl}-3,6-di-*tert*-butyl-9*H*-carbazole (6.64 mmol, 4.6 g) was dissolved in dry THF (100 mL). The resulting mixture was cooled to -78 °C and 2.5 M n-BuLi (8 mmol, 3.2 mL) was slowly added. After the reaction had been stirred intensively for 1h at -78 °C, chlorotributylstannane (9.3 mmol, 2.53 mL) was slowly added. The mixture was stirred overnight. The reaction was quenched with H₂O, diluted with EtOAc, and extracted with EtOAc. The combined organic layers were washed with brine, dried over anhydrous MgSO₄, and concentrated. The resulting product was purified by column chromatography (CH/DCM = 10/1). Yield: 50%
¹H-NMR (δH, ppm, 500 MHz, CDCl₃): 8.18 (s, 2H, Ar); 7.84-7.82 (d, 2H, Ar); 7.71-7.69 (dd, 4H, Ar); 7.64-7.62 (m, 4H, Ar); 7.59-7.57 (d, 2H, Ar); 7.54-7.45 (m, 10H, Ar); 1.64-1.57 (m, 16H); 1.51 (s, 18H); 1.42-1.35 (m, 6H); 1.14-1.10 (m, 6H); 0.96-0.93 (t, 9H). ¹³C-NMR (δH, ppm, 500 MHz, CDCl₃): 144.51; 142.98; 139.45; 138.96; 137.82; 136.48; 136.14; 135.65; 134.16; 129.75; 128.00; 125.70; 123.60; 123.51; 116.25; 109.40; 34.77; 32.05; 29.15; 27.45; 13.74; 9.62.

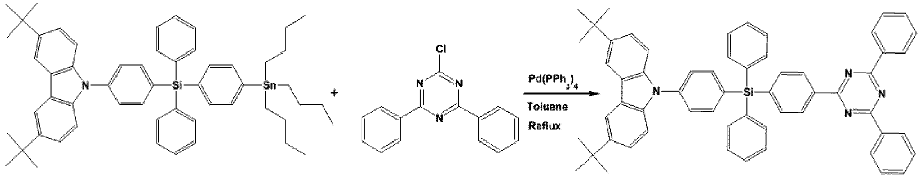

### 3,6-di-tert-butyl-9-{4-[[4-(4,6-diphenyl-1,3,5-triazin-2-yl)phenyl](diphenyl)silyl]phenyl}-9H-carbazole (example compound 1):

Under N₂ atmosphere, a mixture of compound 4 (0.14 mmol, 0.13 g), 2-chloro-4,6-diphenyl-1,3,5-triazine (0.11 mmol, 29.5 mg), and Pd(PPh₃)₄ (0.011 mmol, 12.8 mg) in anhydrous toluene (5 mL) was stirred at 110 °C for 24 hours. Subsequently, the mixture was cooled down to room temperature, diluted with EtOAc, and filtered through a short silica column. The crude product was purified by column chromatography (CH/DCM =10:1).
¹H-NMR (δH, ppm, 400 MHz, CDCl₃): 8.85-8.79 (m, 6H, Ar); 8.17 (s, 2H, Ar); 7.92-7.85 (m, 4H, Ar); 7.75-7.72 (m, 4H, Ar); 7.67-7.57 (m, 8H, Ar); 7.53-7.47 (m, 10H, Ar); 1.50 (s, 18H). ¹³C-NMR (δH, ppm, 400 MHz, CDCl₃): 171.74; 143.06; 139.75; 139.60; 138.95; 137.80; 137.53; 136.76; 136.45; 136.20; 133.56; 132.54; 132.35; 129.97; 128.98; 128.63; 128.18; 128.14; 125.83; 123.61; 123.58; 116.24; 109.38; 34.74; 32.01.

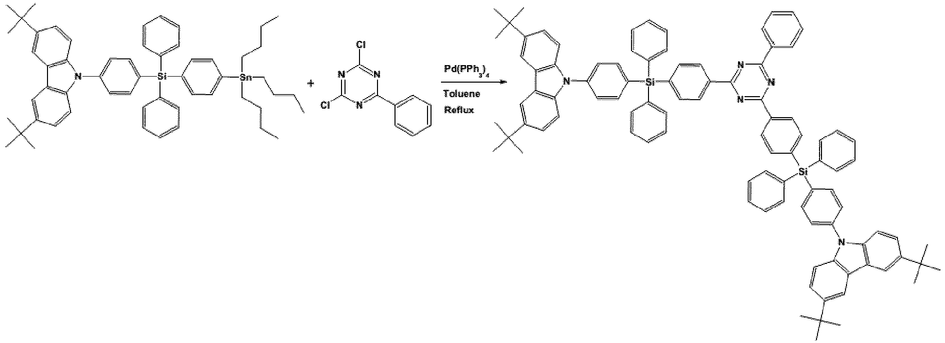

### 9,9'-{(6-phenyl-1,3,5-triazine-2,4-diyl)bis[4,1-phenylene(diphenylsilanediyl)-4,1-phenylene]}bis(3,6-di-tert-butyl-9H-carbazole) (example compound 2):

Under N₂ atmosphere, a mixture of compound 4 (1.00 mmol, 0.90 g), 2,4-dichloro-6-phenyl-1,3,5-triazine (0.45 mmol, 101.7 mg), and Pd(PPh₃)₄ (0.1 mmol, 116 mg) in anhydrous toluene (20 mL) was stirred at 110 °C for 24 hours. Subsequently, the mixture was cooled down to room temperature, diluted with EtOAc, and filtered through a short silica column. The crude product was purified by column chromatography (CH/DCM =5:1).
¹H-NMR (δH, ppm, 400 MHz, CDCl₃): 8.62-8.58 (t, 4H, Ar); 8.15 (s, 4H, Ar); 7.85-7.77 (m, 8H, Ar); 7.71-7.67 (m, 8H, Ar); 7.65-7.59 (m, 5H, Ar); 7.54-7.42 (m, 24H, Ar); 1.48 (s, 36H). ¹³C-NMR (δH, ppm, 400 MHz, CDCl₃): 174.13; 171.82; 153.71; 143.06; 140.37; 139.71; 138.91; 137.76; 136.41; 135.26; 133.85; 133.39; 133.00; 132.54; 132.15; 131.54; 129.92; 129.16; 128.64; 128.09; 125.81; 123.60; 121.48; 116.23; 109.36; 34.73; 32.00.

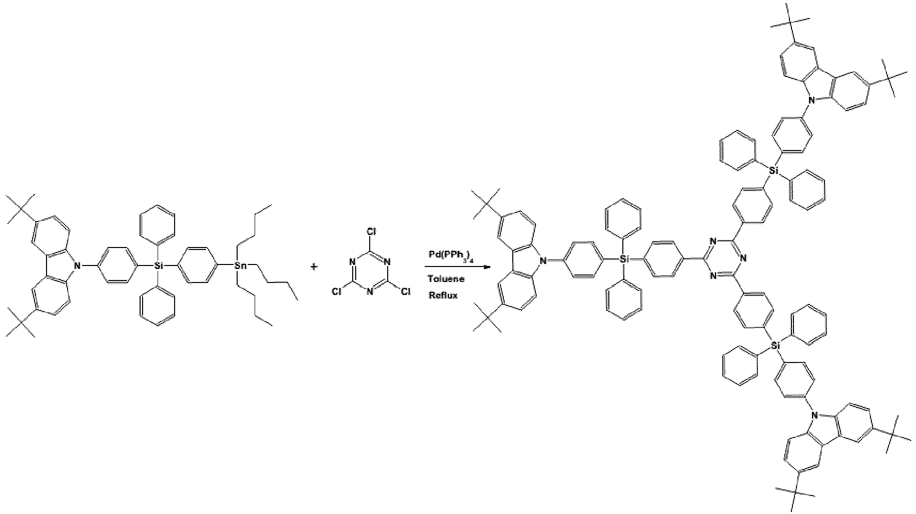

### 9,9',9"-{1,3,5-triazine-2,4,6-triyltris[4,1-phenylene(diphenylsilanediyl)-4,1-phenylene]}tris(3,6-di-tert-butyl-9H-carbazole) (example compound 3):

Under N₂ atmosphere, a mixture of compound 4 (2.21 mmol, 2.00 g), cyanuric chloride (0.7 mmol, 129 mg), and Pd(PPh₃)₄ (0.22 mmol, 255 mg) in anhydrous toluene (20 mL) was stirred at 110 °C for 24 hours. Subsequently, the mixture was cooled down to room temperature, diluted with EtOAc, and filtered through a short silica column. The crude product was purified by column chromatography (CH/DCM =5:1).
¹H-NMR (δH, ppm, 400 MHz, CDCl₃): 8.86-8.85 (d, 6H, Ar); 8.18 (s, 6H, Ar); 7.92-7.90 (d, 6H, Ar); 7.87-7.85 (d, 6H, Ar); 7.75-7.73 (dd, 12H, Ar); 7.67-7.65 (d, 6H, Ar); 7.57-7.48 (m, 30H); 1.50 (s, 54H). ¹³C-NMR (δH, ppm, 400 MHz, CDCl₃): 171.93; 143.06; 139.82; 139.76; 138.95; 137.80; 137.39; 136.79; 136.45; 133.53; 132.30; 129.99; 128.15; 125.84; 123.61; 123.59; 116.24; 109.37; 34.74; 32.02.

**Table 1. Photophysical and electrochemical properties of the synthesized molecules**

| Compounds | Solvent | λ_{abs} (nm)^{a} | λ_{PL} (nm)^{a} | E_{T} (eV)^{b} | Eox^{C} (V) | HOMO (eV)^{d} | LUMO (eV)^{e} | E_{g(opt)} (eV)^{f} |
|---|---|---|---|---|---|---|---|---|
| Example compound 1 | Toluene | 286, 298 | 418 | 2.98 eV (416nm) | 0.89 | -5.59 | 2.09 | 3.5 |
| | 2-MeTHF | 285, 297 | 496 | | | | | |
| | DCM | 286, 297 | 550 | | | | | |
| Example compound 2 | Toluene | 285, 297 | 436 | 3.00 eV 414 nm | 0.87 | -5.57 | 2.07 | 3.5 |
| | 2-MeTHF | 279, 296 | 514 | | | | | |
| | DCM | 283, 297 | 572 | | | | | |

| | | | | | | | | |
|---|---|---|---|---|---|---|---|---|
| ^{a}Maximum absorption ve PL wavelengths, triplet energy values, calculated from the maximum wavelength of the phosphorescence spectra measured in 2-MeTHF at 77 K, ^{c} oxidation potentials, determined from the onset of the CV curves, ^{d}HOMO energy levels, calculated from the onset of the oxidation potentials, ^{e}LUMO=HOMO+E_{g}, ^{f} optical bandgap values, calculated from the onset of the absorption spectra. | | | | | | | | |

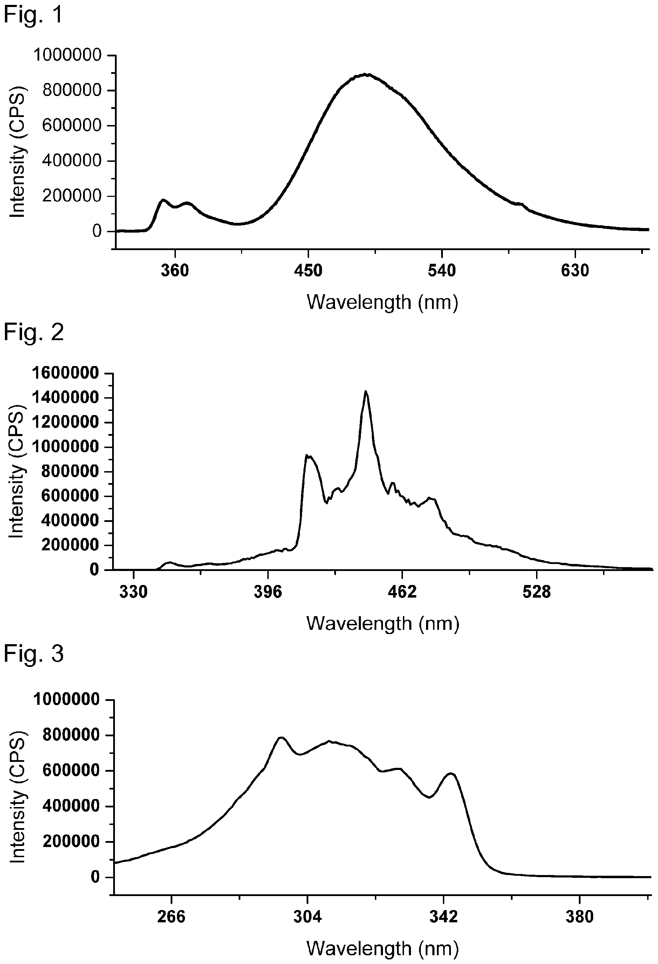

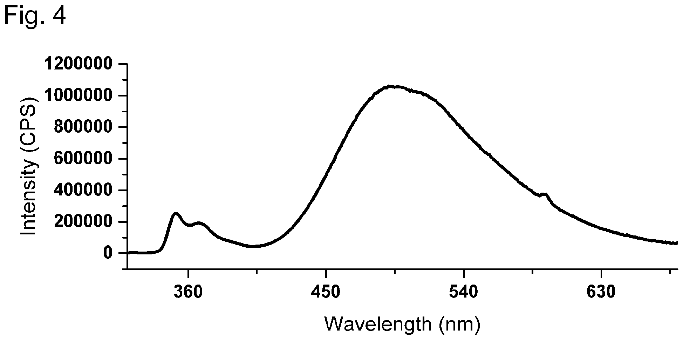

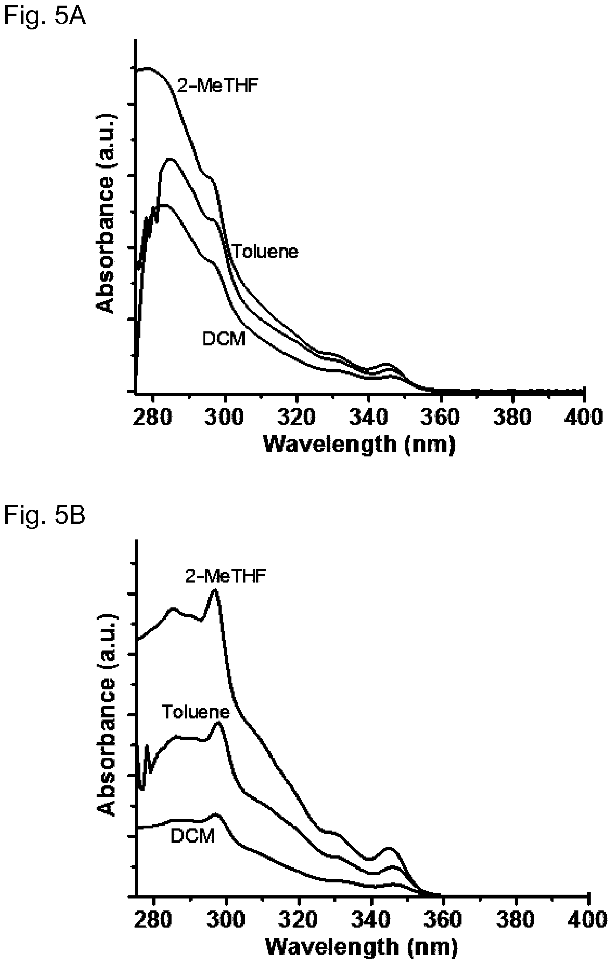

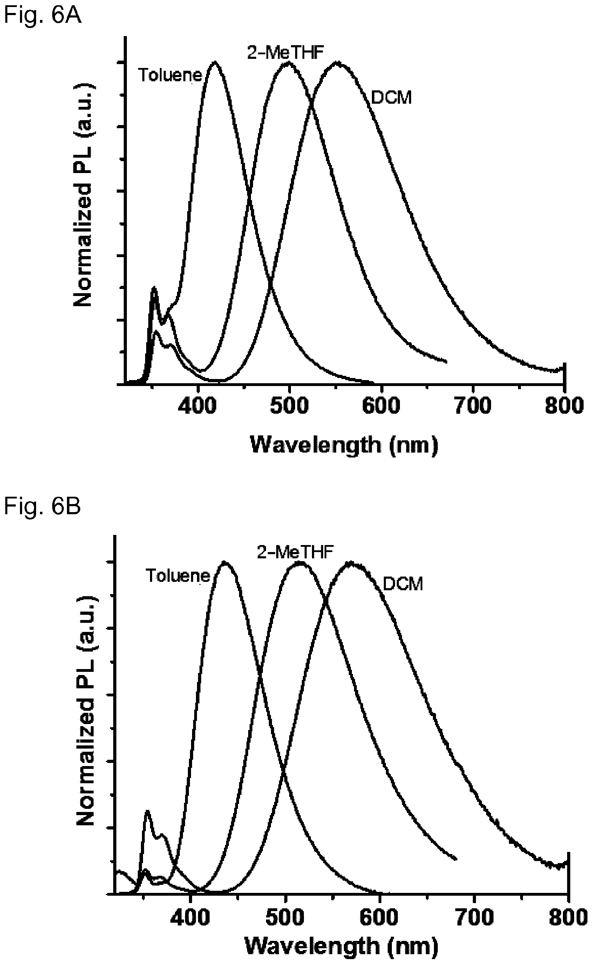

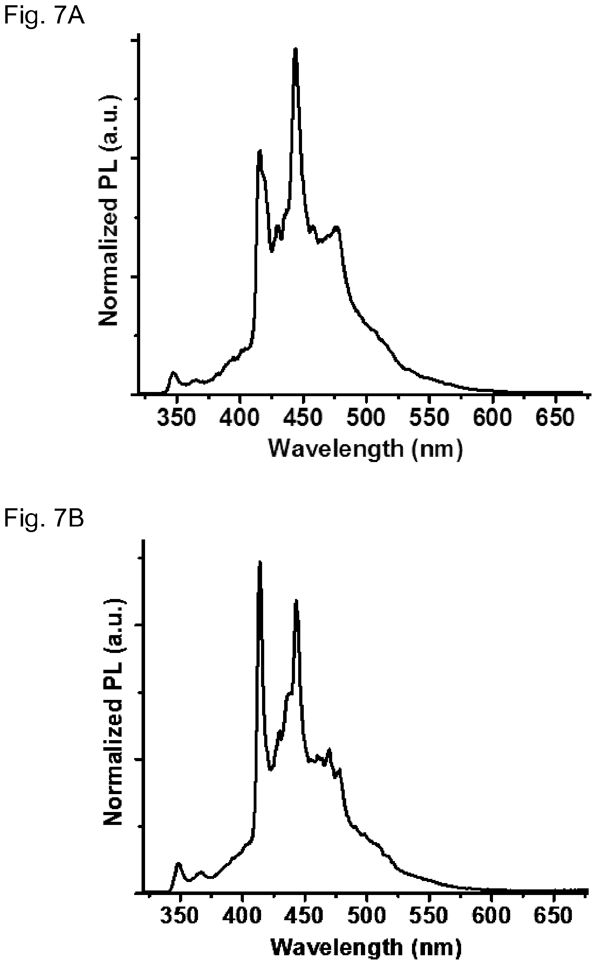

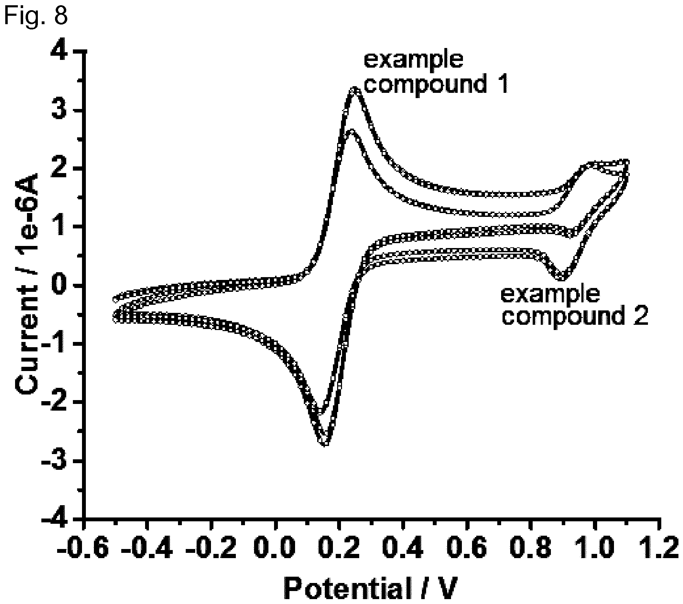

Further results for the photophysical properties of the emitter compounds E as exemplified by example compounds 1 and 2 dissolved in various solvents are depicted in Figures 1 to 8.

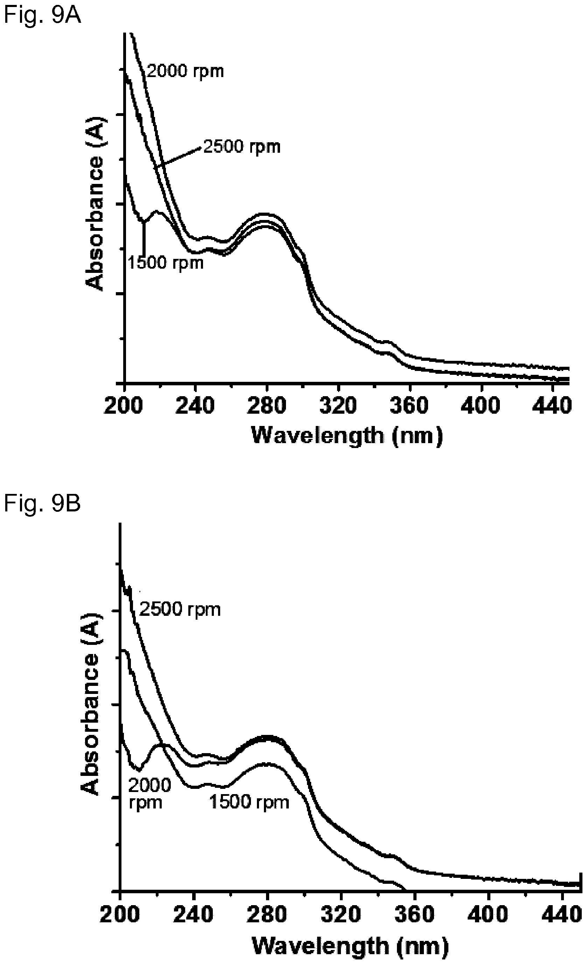

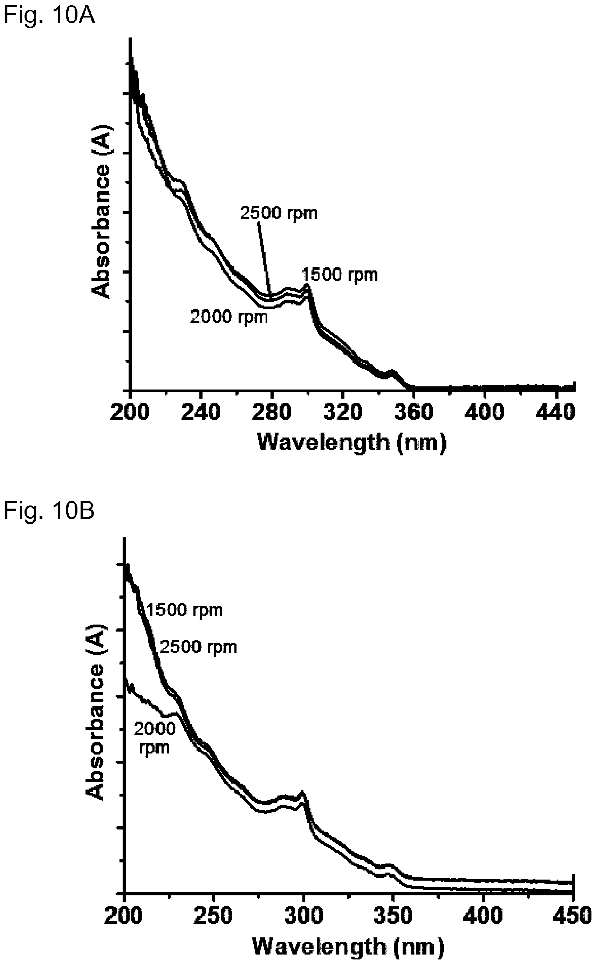

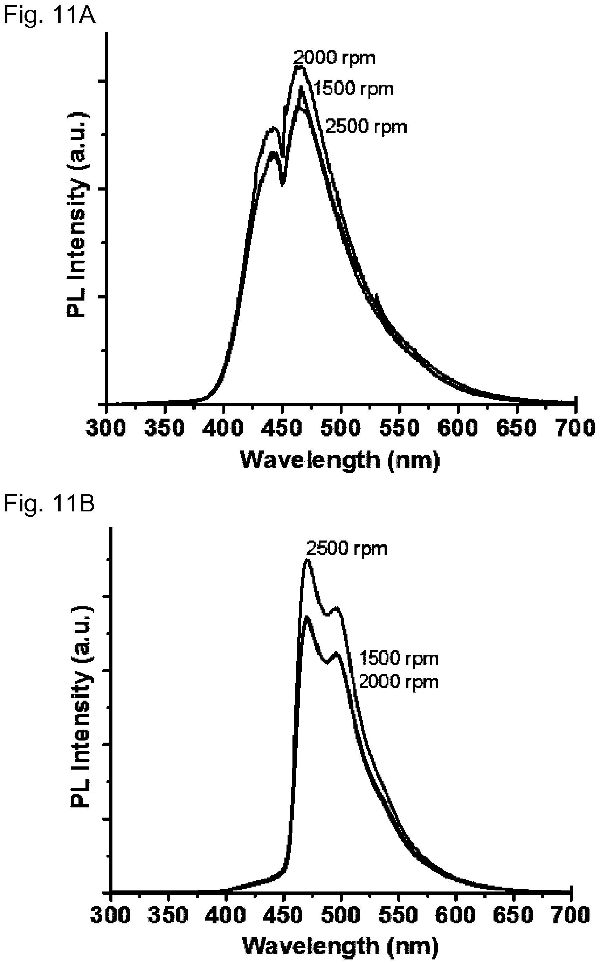

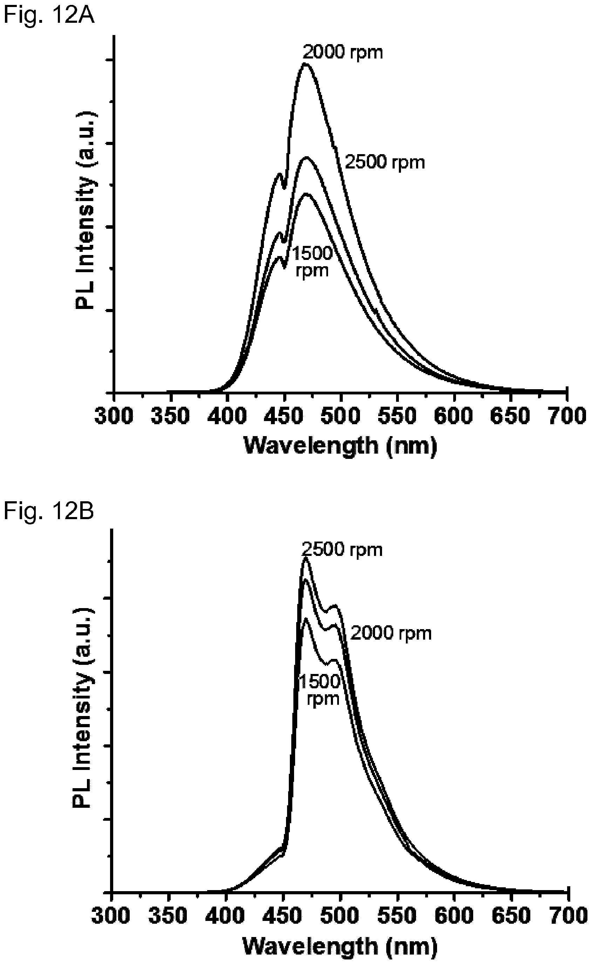

The exemplified compounds were also studied in the film phase as depicted in Figures 9 to 12.

### Further photophysical parameters of the example compound 1

In 10 w-% a poly(methyl methacrylate) (PMMA) film, the example compound 1 has a photophysical quantum yield of 10%. The excited state lifetime in degassed 2-MeTHF is in the order of µs, proofing the TADF-nature of this molecule.

### Density functional theory (DFT)-calculation for the example compound 1

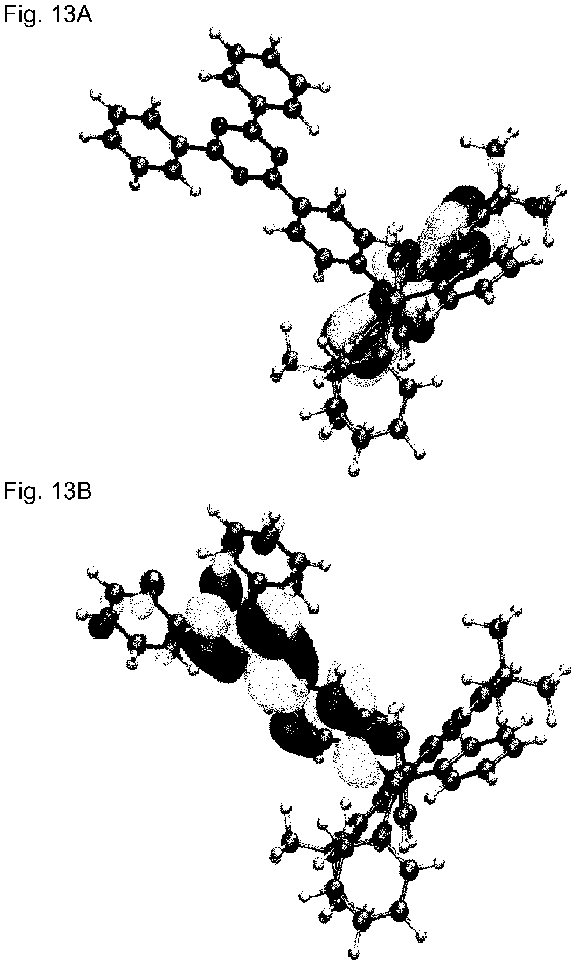

The energetic difference between the S1 and T1 state was calculated with TD-DFT (BP86). With a value of 0.086 eV, the material is a TADF emitter, as indicated by the photophysical analyses in 2-MeTHF. The HOMO and LUMO distribution is depicted in Fig. 13.

## Claims

1. An emitter compound E of formula (I) or a salt thereof: 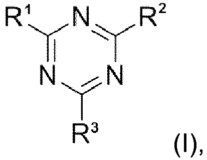 wherein
R¹, R² and R³ are each independently selected from the group consisting of aryl, alkyl-substituted aryl, alkyl, hydrogen, deuterium, heteroaryl, and alkyl-substituted heteroaryl and a moiety of formula (Ia): 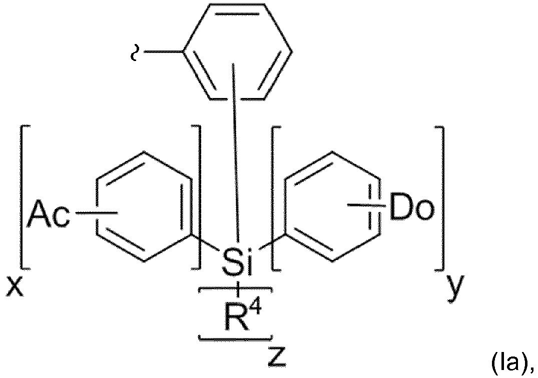 wherein at least one of R¹, R² and R³ is a moiety of formula (Ia);
Do represents a donor moiety of formula (Ib): 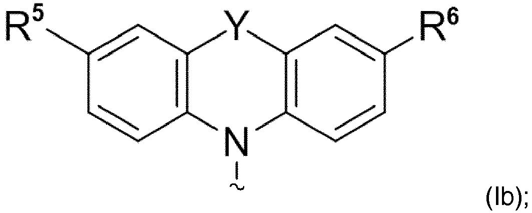
Ac represents an acceptor moiety of formula (Ic): 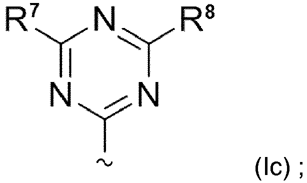
Y is independently selected from the group consisting of a single bond, -O-, -S-, -SO-, -SO₂-, -CR⁹R¹⁰, -(CR⁹R¹⁰)(CR¹¹R¹²)-, -(CR⁹)(CR¹⁰)- or 1,2-phenylene;
R⁴ is independently at each occurrence selected from the group consisting of aryl, alkyl-substituted aryl, alkyl, heteroaryl, and alkyl-substituted heteroaryl;
R⁵ and R⁶ are each a C₁₋₁₀alkyl, wherein R⁵ = R⁶;
R⁷ and R⁸ are each independently selected from the group consisting of aryl, alkyl-substituted aryl, hydrogen, deuterium, alkyl, heteroaryl, and alkyl-substituted heteroaryl;
R⁹, R¹⁰, R¹¹ and R¹² are each independently selected from the group consisting of hydrogen, deuterium, aryl, alkyl-substituted aryl, alkyl, halogen, heteroaryl, and alkyl-substituted heteroaryl;
x is an integer selected from the group consisting of 0, 1 and 2;
y is an integer selected from the group consisting of 1, 2 and 3; and
z is an integer selected from the group consisting of 2, 1 and 0,
wherein x+y+z = 3.

2. The emitter compound E of claim 1, wherein Y is a single bond.

3. The emitter compound E of claims 1 or 2, wherein x = 0, y = 1, and z = 2.

4. The emitter compound E of any of claims 1 to 3, wherein one, two or three of R¹, R² and R³ are each a moiety of formula (Ia).

5. The emitter compound E of any of claims 1 to 4, wherein each R⁴ is an aryl residue of each not more than 20 carbon atoms, in particular are each a phenyl residue.

6. The emitter compound E of any of claims 1 to 5, wherein one, two or three of R¹, R² and R³ each represent a moiety of formula (Id): 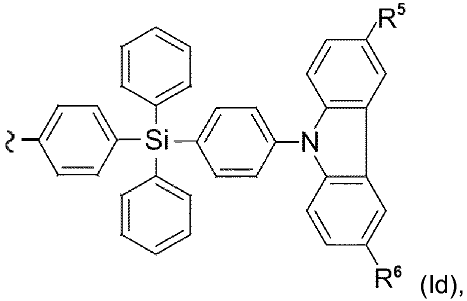 wherein R⁵ and R⁶ are defined as above.

7. The emitter compound E of any of claims 1 to 6, wherein R⁵ and R⁶ are each selected from the group consisting of tert.-butyl, isopropyl, ethyl, methyl, n-butyl, and n-propyl.

8. The emitter compound E of any of claims 1 to 7, wherein said emitter compound E is a thermally activated delayed fluorescence (TADF) emitter.

9. The emitter compound E of claim 8, wherein the energy difference between the first excited singlet state S1 and the first excited triplet state T1 ΔE(S1-T1) is not higher than 7000 cm⁻¹, preferably not higher than 6000 cm⁻¹, more preferably not higher than 5000 cm⁻¹, even more preferably not higher than 3000 cm⁻¹, even more preferably not higher than 2000 cm⁻¹, even more preferably not higher than 1500 cm⁻¹, in particular not higher than 1000 cm⁻¹.

10. A light-emitting layer B comprising:
(a) at least one emitter compound E of any of claims 1 to 9, and
(b) optionally, one or more host components (c), one or more dyes and/or one or more solvents.

11. An opto-electronic device OD comprising a light-emitting layer B according to claim 10.

12. The opto-electronic device OD of claim 11, wherein said opto-electronic device OD is a device selected from the group consisting of an organic light emitting diode, a light emitting electrochemical cell, a transistor, a light-emitting transistor, an organic solar cell, and an optical sensor.

13. The opto-electronic device OD of any of claims 11 or 12, comprising at least the layers:
(A) an anode layer A, preferably comprising indium tin oxide, indium zinc oxide, PbO, SnO, graphite, doped silicium, doped germanium, doped GaAs, doped polyaniline, doped polypyrrole and/or doped polythiophene;
(B) a light-emitting layer B of claim 10; and
(C) a cathode layer C, preferably comprising Al, Au, Ag, Pt, Cu, Zn, Ni, Fe, Pb, In, W, Pd, LiF, Ca, Ba, Mg, and/or mixtures or alloys of two or more thereof.

14. A method for generating light of a desired wavelength range, comprising the steps of:
(i) providing an opto-electronic device OD of any of claims 11 to 13; and
(ii) lead an electrical current flow through the light-emitting layer B comprised in the opto-electronic device OD.

15. The method of claim 14, wherein the generated light has an emission maximum in the range of from 380 to 575 nm.

## Patentansprüche

1. Emitterverbindung E der Formel (I) oder ein Salz davon: 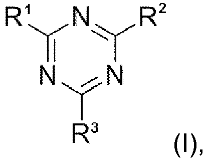 wobei
R¹, R² und R³ jeweils unabhängig ausgewählt sind aus der Gruppe bestehend aus Aryl, alkylsubstituiertem Aryl, Alkyl, Wasserstoff, Deuterium, Heteroaryl und alkylsubstituiertem Heteroaryl und einem Rest der Formel (la): 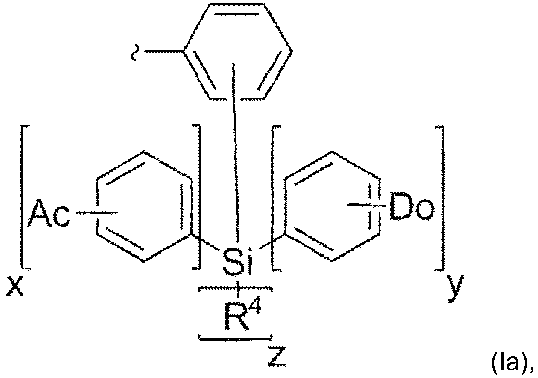 wobei mindestens einer von R¹, R² und R³ ein Rest der Formel (la) ist;
Do einen Donor-Rest der Formel (Ib) darstellt: 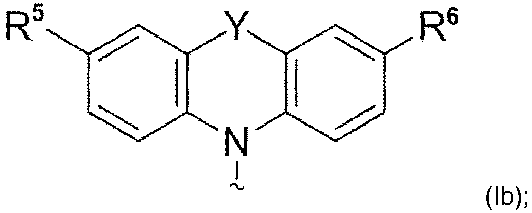
Ac einen Akzeptor-Rest der Formel (Ic) darstellt: 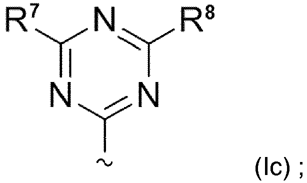
Y unabhängig ausgewählt ist aus der Gruppe bestehend aus einer Einfachbindung, -O-, -S-, -SO-, -SO₂-, -CR⁹R¹⁰, -(CR⁹R¹⁰)(CR¹¹R¹²)- , -(CR⁹)(CR¹⁰)- oder 1,2-Phenylen;
R⁴ bei jedem Auftreten unabhängig voneinander ausgewählt ist aus der Gruppe bestehend aus Aryl, alkylsubstituiertem Aryl, Alkyl, Heteroaryl und alkylsubstituiertem Heteroaryl;
R⁵ und R⁶ jeweils ein C₁₋₁₀-Alkyl sind, wobei R⁵ = R⁶;
R⁷ und R⁸ jeweils unabhängig voneinander ausgewählt sind aus der Gruppe bestehend aus Aryl, alkylsubstituiertem Aryl, Wasserstoff, Deuterium, Alkyl, Heteroaryl und alkylsubstituiertem Heteroaryl;
R⁹, R¹⁰, R¹¹ und R¹² jeweils unabhängig voneinander ausgewählt sind aus der Gruppe bestehend aus Wasserstoff, Deuterium, Aryl, alkylsubstituiertem Aryl, Alkyl, Halogen, Heteroaryl und alkylsubstituiertem Heteroaryl;
x eine ganze Zahl ausgewählt aus der Gruppe bestehend aus 0, 1 und 2 ist;
y eine ganze Zahl ausgewählt aus der Gruppe bestehend aus 1, 2 und 3 ist; und
z eine ganze Zahl ausgewählt aus der Gruppe bestehend aus 2, 1 und 0 ist,
wobei x+y+z = 3.

2. Emitterverbindung E nach Anspruch 1, wobei Y eine Enfachbindung ist.

3. Emitterverbindung E nach Ansprüchen 1 oder 2, wobei x = 0, y = 1 und z = 2.

4. Emitterverbindung E nach einem beliebigen der Ansprüche 1 bis 3, wobei einer, zwei oder drei aus R¹, R² und R³ jeweils ein Rest der Formel (la) sind.

5. Emitterverbindung E nach einem beliebigen der Ansprüche 1 bis 4, wobei jedes R⁴ ein Arylrest von jeweils nicht mehr als 20 Kohlenstoffatomen ist, insbesondere jeweils ein Phenylrest ist.

6. Emitterverbindung E nach einem beliebigen der Ansprüche 1 bis 5, wobei einer, zwei oder drei aus R¹, R² und R³ jeweils einen Rest der Formel (Id) darstellt: 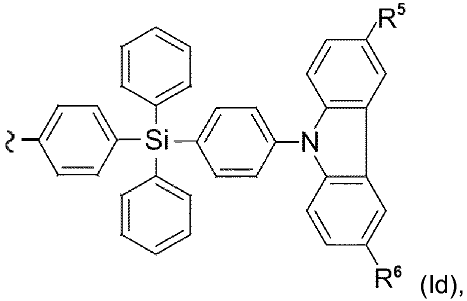 wobei R⁵ und R⁶ wie oben definiert sind.

7. Emitterverbindung E nach einem beliebigen der Ansprüche 1 bis 6, wobei R⁵ und R⁶ jeweils ausgewählt sind aus der Gruppe bestehend aus tert.-Butyl, Isopropyl, Ethyl, Methyl, n-Butyl und n-Propyl.

8. Emitterverbindung E nach einem beliebigen der Ansprüche 1 bis 7, wobei die Emitterverbindung E ein thermisch aktivierter verzögerter Fluoreszenz-(TADF-)Emitter ist.

9. Emitterverbindung E nach Anspruch 8, wobei die Energiedifferenz zwischen dem ersten angeregten Singulett-Niveau S1 und dem ersten angeregten Triplett-Niveau T1 ΔE(S1-T1) nicht größer als 7000 cm⁻¹, bevorzugt nicht größer als 6000 cm⁻¹, stärker bevorzugt nicht größer als 5000 cm⁻¹, noch stärker bevorzugt nicht größer als 3000 cm⁻¹, noch stärker bevorzugt nicht größer als 2000 cm⁻¹, noch stärker bevorzugt nicht größer als 1500 cm⁻¹, insbesondere nicht größer als 1000 cm⁻¹ ist.

10. Lichtemmittierende Schicht B, umfassend:
(a) mindestens eine Emitterverbindung E nach einem beliebigen der Ansprüche 1 bis 9, and
(b) optional eine oder mehrere Wirtsverbindungen (c), ein oder mehrere Farbstoffe und/oder ein oder mehrere Lsungsmittel.

11. Optoelektronische Vorrichtung OD umfassend eine lichtemmittierende Schicht B gemäß Anspruch 10.

12. Optoelektronische Vorrichtung OD nach Anspruch 11, wobei die optoelektronische Vorrichtung OD eine Vorrichtung ausgewählt aus der Gruppe bestehend aus einer organischen lichtemittierenden Diode, einer lichtemittierenden elektrochemischen Zelle, einem Transistor, einem lichtemittierenden Transistor, einer organischen Solarzelle und einem optischen Sensor ist.

13. Optoelektronische Vorrichtung OD nach einem beliebigen der Ansprüche 11 oder 12, umfassend mindestens die Schichten:
(A) eine Anodenschicht A, bevorzugt umfassend Indiumzinnoxid, Indiumzinkoxid, PbO, SnO, Graphit, dotiertes Silicium, dotiertes Germanium, dotiertes GaAs, dotiertes Polyanilin, dotiertes Polypyrrol und/oder dotiertes Polythiophen;
(B) eine lichtemmittierende Schicht B nach Anspruch 10; und
(C) eine Kathodenschicht C, bevorzugt umfassend Al, Au, Ag, Pt, Cu, Zn, Ni, Fe, Pb, In, W, Pd, LiF, Ca, Ba, Mg und/oder Mischungen oder Legierungen von zwei oder mehr daraus.

14. Verfahren zum Erzeugen von Licht eines gewünschten Wellenlängenbereichs, umfassend die Schritte:
(i) Bereitstellen einer optoelektronischen Vorrichtung OD nach einem beliebigen der Ansprüche 11 bis 13; und
(ii) Leiten eines elektrischen Stromflusses durch die lichtemmittierende Schicht B, die in der optoelektronischen Vorrichtung OD enthalten ist.

15. Verfahren nach Anspruch 14, wobei das erzeugte Licht ein Emissionsmaximum im Bereich von 380 bis 575 nm hat.

## Revendications

1. Composé émetteur E de formule (I) ou sel de celui-ci : 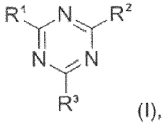 dans lequel
R¹, R² et R³ sont chacun indépendamment choisis dans le groupe constitué par un aryle, un aryle à substitution alkyle, un alkyle, un hydrogène, un deutérium, un hétéroaryle, et un hétéroaryle à substitution alkyle et un groupement de formule (la) : 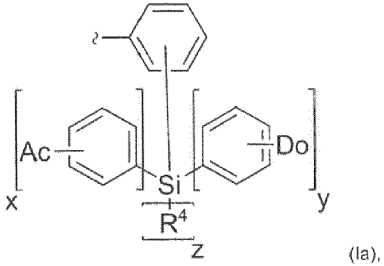 au moins un de R¹, R² et R³ étant un groupement de formule (Ia) ;
Do représente un groupement donneur de formule (Ib) : 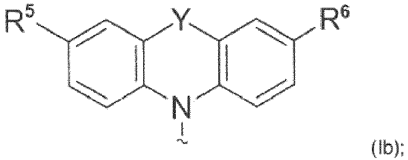 Ac représente un groupement accepteur de formule (Ic) : 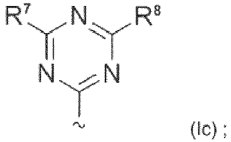
Y est indépendamment choisi dans le groupe constitué par une simple liaison, -O-, -S-, -SO-, -SO₂-, -CR⁹R¹⁰, -(CR⁹R¹⁰)(CR¹¹R¹²)-, -(CR⁹)(CR¹⁰)- ou un 1,2-phénylène ;
R⁴ est indépendamment choisi à chaque occurrence dans le groupe constitué par un aryle, un aryle à substitution alkyle, un alkyle, un hétéroaryle, et un hétéroaryle à substitution alkyle ;
R⁵ et R⁶ représentent chacun un alkyle en C₁₋₁₀, avec R⁵ = R⁶ ;
R⁷ et R⁸ sont chacun indépendamment choisis dans le groupe constitué par un aryle, un aryle à substitution alkyle, un hydrogène, un deutérium, un alkyle, un hétéroaryle, et un hétéroaryle à substitution alkyle ;
R⁹, R¹⁰, R¹¹ et R¹² sont chacun indépendamment choisis dans le groupe constitué par un hydrogène, un deutérium, un aryle, un aryle à substitution alkyle, un alkyle, un halogène, un hétéroaryle, et un hétéroaryle à substitution alkyle ;
x est un entier choisi dans le groupe constitué par 0, 1 et 2 ;
y est un entier choisi dans le groupe constitué par 1, 2 et 3 ; et
z est un entier choisi dans le groupe constitué par 2, 1 et 0,
avec x+y+z = 3.

2. Composé émetteur E de la revendication 1, dans lequel Y est une simple liaison.

3. Composé émetteur E des revendications 1 ou 2, dans lequel x = 0, y = 1, et z = 2.

4. Composé émetteur E de l'une quelconque des revendications 1 à 3, dans lequel un, deux ou trois de R¹, R² et R³ sont chacun un groupement de formule (la).

5. Composé émetteur E de l'une quelconque des revendications 1 à 4, dans lequel chaque R⁴ est un résidu aryle, chacun de pas plus de 20 atomes de carbone, en particulier chacun est un résidu phényle.

6. Composé émetteur E de l'une quelconque des revendications 1 à 5, dans lequel un, deux ou trois de R¹, R² et R³ représentent chacun un groupement de formule (Id) : 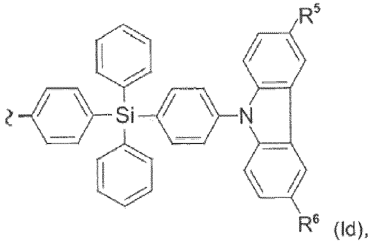 dans lequel R⁵ et R⁶ sont définis comme ci-dessus.

7. Composé émetteur E de l'une quelconque des revendications 1 à 6, dans lequel R⁵ et R⁶ sont chacun choisis dans le groupe constitué par les radicaux tert-butyle, isopropyle, éthyle, méthyle, n-butyle, et n-propyle.

8. Composé émetteur E de l'une quelconque des revendications 1 à 7, ledit composé émetteur E étant un émetteur de fluorescence retardée activée thermiquement (TADF).

9. Composé émetteur E de la revendication 8, dans lequel la différence d'énergie entre le premier état singulet excité S1 et le premier état triplet excité T1 □E(S1-T1) n'est pas supérieure à 7000 cm⁻¹, de préférence pas supérieure à 6000 cm⁻¹, mieux pas supérieure à 5000 cm⁻¹, mieux encore pas supérieure à 3000 cm⁻¹, mieux pas supérieure à 2000 cm⁻¹, mieux encore pas supérieure à 1500 cm⁻¹, en particulier pas supérieure à 1000 cm⁻¹.

10. Couche émettrice de lumière B comprenant :
(a) au moins un composé émetteur E de l'une quelconque des revendications 1 à 9, et
(b) éventuellement, un ou plusieurs composants hôtes (c), un ou plusieurs colorants et/ou un ou plusieurs solvants.

11. Dispositif optoélectronique OD comprenant une couche émettrice de lumière B selon la revendication 10.

12. Dispositif optoélectronique OD de la revendication 11, ledit dispositif optoélectronique OD étant un dispositif choisi dans le groupe constitué par une diode électroluminescente organique, une cellule électrochimique électroluminescente, un transistor, un transistor électroluminescent, une cellule solaire organique, et un capteur optique.

13. Dispositif optoélectronique OD de l'une quelconque des revendications 11 ou 12, comprenant au moins les couches :
(A) une couche anodique A, comprenant de préférence de l'oxyde d'indium et d'étain, de l'oxyde d'indium et de zinc, du PbO, du SnO, du graphite, du silicium dopé, du germanium dopé, du GaAs dopé, de la polyaniline dopée, du polypyrrole dopé et/ou du polythiophène dopé ;
(B) une couche émettrice de lumière B de la revendication 10 ; et
(C) une couche cathodique C, comprenant de préférence Al, Au, Ag, Pt, Cu, Zn, Ni, Fe, Pb, In, W, Pd, LiF, Ca, Ba, Mg, et/ou des mélanges ou alliages d'au moins deux d'entre eux.

14. Procédé destiné à générer de la lumière d'une gamme de longueurs d'onde souhaitée, comprenant les étapes consistant à :
(i) se procurer un dispositif optoélectronique OD de l'une quelconque des revendications 11 à 13 ; et
(ii) faire circuler un courant électrique à travers la couche émettrice de lumière B contenue dans le dispositif optoélectronique OD.

15. Procédé de la revendication 14, dans lequel la lumière générée a un maximum d'émission dans la gamme de 380 à 575 nm.
